# EUROPEAN PATENT APPLICATION

(11) **EP 3 318 611 A1**
(43) Date of publication of application: **09.05.2018**
(21) Application number: 16817773.1
(22) Date of filing: 21.06.2016
(51) Int. Cl.: C09C 1/00, B01J 2/00, B01J 3/08, C08K 9/02, C09K 3/00, C23C 18/52, C23C 24/04, C23C 24/08

(54) **COATED PARTICLES**

(30) Priority: 01.07.2015 JP 2015133153
(71) Applicant: Kabushiki Kaisha Kobe Seiko Sho (Kobe Steel, Ltd.), Kobe-shi, Hyogo 651-8585 (JP)
(72) Inventor: WADA, Ryutaro, Tokyo 141-8688 (JP); UEDA, Masaya, Kobe-shi, Hyogo 651-8585 (JP)
(74) Representative: Müller-Boré & Partner Patentanwälte PartG mbB
(86) International application number: PCT/JP2016/068355
(87) International publication number: WO 2017/002665

(57) **Abstract**

Provided is a new material produced by a detonation method using a non-gunpowder-based starting material which is inexpensive and is capable of stable supply, using carbon particles which include nanoscale graphite carbon and diamond. These coated particles are constituted by carbon particles, which are produced by a step for disposing an explosive material having a detonation velocity of 6300 m/s or more around a starting material including an aromatic compound having two or fewer nitro groups, and a step for detonating the explosive material, being coated on the surface of base material particles.

## Description

### Technical Field

The present invention relates to coated particles constituted by coating surfaces of base material particles with carbon particles obtained by a detonation method.

### Background Art

Nano-scale diamond (also referred to as "nanodiamond") has a large number of excellent properties such as a high hardness and an extremely low coefficient of friction, and therefore, it has been already utilized in various fields and its development of application has been investigated as an extremely promising new material.

It has been known that nanodiamond can be synthesized by, for example, utilizing a detonation reaction of a high explosive. This synthesis method is generally called a detonation method, in which detonation is performed with only a raw material substance containing an aromatic compound having three or more nitro groups (hereinafter referred to as "low explosive raw material") as a carbon source, and carbon atoms decomposed and liberated from a molecule constituting the low explosive raw material by the detonation reaction are formed as diamond at high temperature and high pressure during the detonation (for example, see Non-Patent Literature 1).

The production of nanodiamond by the detonation method has hitherto been performed in, for example, the East European countries such as Russia and the Ukraine, the United States of America, China, and the like. In these countries, since a military waste low explosive is inexpensively available as the low explosive raw material that is the carbon source, trinitrotoluene (TNT), an explosive mixture of TNT and hexogen (RDX: trimethylenetrinitramine) or octogen (HMX: cyclotetramethylenetetranitramine), or the like has been used.

In the present invention, a high explosive means a substance capable of performing a detonation reaction, and examples thereof may include not only a low explosive raw material but also a raw material substance containing an aromatic compound having two or less nitro groups (hereinafter referred to as "non-explosive raw material"). In addition, an explosive substance means a substance causing a sudden combustion reaction, and may be a solid one or a liquid one at normal temperature and normal pressure.

It is anticipated that the demanded amount of nanodiamond will increase more and more in the future with the development of its application. However, as for the production using a military waste low explosive, there is a limit in the production volume. Therefore, there is a possibility that the supply may be short in the international market in the future. Then, the domestic production is expected. However, based on previous evaluation by the present inventors, it has been found that the aforementioned low explosive raw material is expensive enough to increase the production cost to thereby cause unprofitability in economy.

### Citation List

### Patent Literature

Patent Literature 1: Japanese Patent No. 4245310
Patent Literature 2: Japanese Patent No. 5155975

### Non-Patent Literature

Non-Patent Literature 1: Yozo Kakudate (author), "2-3. Dynamic High Pressure (Detonation Method)", Industrial Diamond Association of Japan (editor), "Handbook of Diamond Technology", NGT, January 2007, pp. 28 to 33

### Summary of the Invention

### Technical Problems

Carbon particles produced by a detonation method contain not only nanodiamond but also carbon impurities mainly including nano-scale graphite carbon (hereinafter referred to as "nanographite") which is a carbon component having no diamond structure. That is, the raw material substance causes detonation, whereby the raw material substance is decomposed to an atomic level, and carbon atoms liberated therefrom without being oxidized aggregate in a solid state to form carbon particles. During the detonation, the raw material substance is in a high-temperature high-pressure state due to a decomposition reaction. However, the raw material substance is immediately expanded and cooled. This process from the high-temperature high-pressure state to the reduced-pressure and cooling state is caused within a very short time as compared with deflagration that is an explosion phenomenon slower than normal combustion or detonation, and therefore, there is no time when the aggregated carbon grows largely. Thus, nano-scale diamond is formed. When a high explosive (such as an explosive mixture of TNT and RDX) known as a typical high explosive causing detonation is used as the raw material substance, pressure during the detonation becomes high enough to allow produced carbon particles to contain plenty of nanodiamond as expected easily from a thermodynamic equilibrium phase diagram of carbon. On the other hand, carbon atoms that do not form a diamond structure become nano-scale graphite carbon (nanographite) or the like.

Of carbon particles, nanographite etc. other than nanodiamond have been regarded as undesired in order to use the excellent properties of nanodiamond. Therefore, the background art has focused on how to eliminate carbon impurities such as nanographite as much as possible to thereby purify nanodiamond by various purification methods or chemical treatments (for example, see Patent Literature 1 or 2). However, nanographite is, for example, lower in hardness than nanodiamond, and higher in electric conductivity than nanodiamond. In addition to such different physical properties from nanodiamond, nanographite has the feature that various kinds of atoms or functional groups other than carbon can be coupled with nanographite so that new functions can be provided. Accordingly, nanographite has attracted attention as a promising new material capable of providing various properties when it is used alone or as a mixture with nanodiamond.

An object of the present invention is to provide a new material using carbon particles containing nano-scale graphite carbon and diamond and produced by a detonation method using a non-explosive raw material that can be supplied at a low price and stably.

### Solution to Problems

In the coated particle in the present invention which could solve the above problem(s), a surface of a base material particle is coated with a carbon particle, the carbon particle being produced by the steps of: disposing an explosive substance with a detonation velocity of 6,300 m/sec or higher in a periphery of a raw material substance containing an aromatic compound having two or less nitro groups; and detonating the explosive substance.

It is preferred that the carbon particle has been fluorinated.

The present invention encompasses a functional material in which the coated particle is supported on a surface of a substrate material.

The coated particle in the present invention can be produced by a method including the steps of: disposing an explosive substance with a detonation velocity of 6,300 m/sec or higher in a periphery of a raw material substance containing an aromatic compound having two or less nitro groups; detonating the explosive substance; and coating a surface of a base material particle with an obtained carbon particle by a mechanical combination method.

The carbon particle may be subjected to a fluorination treatment, and then, the surface of the base material particle may be coated with the carbon particle by the mechanical combination method.

The functional material in the present invention can be produced by supporting the coated particle obtained by the above method on a surface of a substrate material. The functional material in the present invention may be produced by supporting the coated particle obtained by the above method on a surface of a substrate material, followed by subjecting to a fluorination treatment. The coated particle may be supported on the surface of the substrate material by, e.g. thermal spraying, rolling or plating.

### Advantageous Effects of Invention

In the present invention, stable denotation can be generated even by a denotation method using an inexpensive non-explosive raw material, so as to produce carbon particles containing nano-scale graphite carbon and diamond. When surfaces of base material particles are coated with the carbon particles obtained thus, a new material can be provided.

### Brief Description of the Drawings

[FIG. 1] FIG. 1 is a sectional diagram schematically showing an example of an explosive device used in a production method of the present invention.
[FIG. 2] FIG. 2 is a schematic diagram for explaining a process of mechanical combination.
[FIG. 3] FIG. 3 shows transmission electron microscopic (TEM) photographs of carbon particles obtained in Experimental Example 3.
[FIG. 4] FIG. 4 shows a transmission electron microscopic (TEM) photograph of the carbon particles obtained in Experimental Example 3.
[FIG. 5] FIG. 5 is an X-ray diffraction chart of the carbon particles obtained in Experimental Example 3.
[FIG. 6] FIG. 6 is a graph showing a calibration curve used for determining the content proportion of diamond in carbon particles.
[FIG. 7] FIG. 7 shows drawing substitute photographs taken by a transmission electron microscope (TEM) before and after fluorination of carbon particles obtained in Experimental Example 4.
[FIG. 8] FIG. 8 is a schematic diagram showing a C1s narrow-band photoelectron spectrum subjected to separation of peaks.
[FIG. 9] FIG. 9 shows a drawing substitute photograph in which surfaces of coated particles obtained in an example were taken by a field emission scanning electron microscope (FE-SEM).
[FIG. 10] FIG. 10 shows a drawing substitute photograph in which a part of a surface layer of a coated particle obtained in an example was cut out by a focused ion beam (FIB) apparatus and the coated particle was taken so that an internal urethane resin particle could be compared with a carbon particle coating the urethane resin particle.
[FIG. 11] FIG. 11 shows drawing substitute photographs in which a section of a coated particle obtained in an example was observed and taken by a field emission scanning electron microscope (FE-SEM).
[FIG. 12] FIG. 12 shows drawing substitute photographs in which a SUS304 stainless steel sheet used as a substrate material and an obtained functional material were taken.
[FIG. 13] FIG. 13 shows drawing substitute photographs in which the functional material shown in FIG. 12 was cut by a fine cutter, and a section of the functional material was observed and taken by a field emission scanning electron microscope (FE-SEM).
[FIG. 14] FIG. 14 is a graph showing results of friction coefficients of samples measured in examples.

### Description of Embodiments

The present inventors studied a method in which carbon particles containing nano-scale graphite carbon and diamond can be produced inexpensively by a detonation method. As a result, the present inventors found that inexpensive production can be attained by a production method including a step of disposing an explosive substance with a detonation velocity of 6,300 m/sec or higher in a periphery of a raw material substance containing an aromatic compound having two or less nitro groups, and a step of detonating the explosive substance. Thus, the present inventors filed a patent application as Japanese Patent Application No. 2013-273468. After that, as a result of further extensive studies, the present inventors found that coated particles in which surfaces of base material particles are coated with carbon particles obtained by the aforementioned production method are useful as a new material. Thus, the present inventors completed the present invention.

First, description will be made about a method for producing the aforementioned carbon particles. The method for producing the carbon particles, which will be described below, is the same as that in the aforementioned Japanese Patent Application No. 2013-273468.

### «Method for Producing Carbon Particles»

As coated particles for use in the present invention, carbon particles containing nano-scale graphite carbon and diamond are produced by a detonation method. More specifically, carbon particles can be produced by a production method including a step of disposing an explosive substance with a detonation velocity of 6,300 m/sec or higher in a periphery of a raw material substance containing an aromatic compound having two or less nitro groups, and a step of detonating the explosive substance.

In the aforementioned production method, first, an explosive substance with a detonation velocity of 6,300 m/sec or higher is disposed in a periphery of a raw material substance containing an aromatic compound having two or less nitro groups. The aromatic compound having two or less nitro groups is a non-explosive raw material contained in the raw material substance as a carbon source for the detonation method. The explosive substance with a detonation velocity of 6,300 m/sec or higher is a substance causing stable detonation to produce carbon particles from the raw material substance. When a molecule forming the explosive substance contains carbon atoms, the explosive substance may serve as a carbon source together with the raw material substance.

Examples of the aromatic compound having two or less nitro groups may include a compound having a structure in which 0, 1 or 2 hydrogen atom(s) of an aromatic ring such as benzene, toluene, xylene, naphthalene or anthracene are substituted with nitro group(s).

The aforementioned aromatic compound may have a substituent other than the nitro groups. Examples of such substituents may include an alkyl group, a hydroxy group, a hydroxyalkyl group, an amino group, a halogen group, and the like.

There may be a case where position isomers are present depending on the positional relation of the nitro groups or the substituents. However, all of the position isomers can be used in the aforementioned production method. For example, when the aromatic compound is nitrotoluene, 3 kinds of isomers, that is, 2-, 3- and 4-nitrotoluenes are conceivable.

Examples of such an aromatic compound having two or less nitro groups may include benzene, toluene, xylene, naphthalene, anthracene, nitrobenzene, nitrotoluene, nitroxylene, nitronaphthalene, nitroanthracene, dinitrobenzene, dinitrotoluene, dinitroxylene, dinitronaphthalene, dinitroanthracene, etc. Each of the aromatic compounds each having two or less nitro groups may be used alone, or two or more kinds of the aromatic compounds each having two or less nitro groups may be used together.

It is preferred that the aromatic compound having two or less nitro groups is a compound having a structure in which 1 or 2 hydrogen atom(s) of an aromatic ring are substituted with nitro group(s). Of such aromatic compounds each having two or less nitro groups, for example, dinitrotoluene (DNT), dinitrobenzene (DNB), dinitroxylene (DNX), and the like are preferred in terms of their low melting points and molding easiness.

The raw material substance may contain a low explosive raw material in addition to the aromatic compound having two or less nitro groups as a non-explosive raw material. The low-explosive raw material is, for example, a compound having three or more nitro groups, which is generally a nitro compound to be used for explosion. Examples of such nitro compounds may include trinitrotoluene (TNT), hexogen (RDX; cyclotrimethylenetrinitramine), octogen (HMX; cyclotetramethylenetetranitramine), pentaerythritol tetranitrate (PETN), tetryl (tetranitromethylaniline), and the like. Each of the nitro compounds may be used alone, or two or more kinds of the nitro compounds may be used together.

The content proportion of the aromatic compound having two or less nitro groups in the aforementioned raw material substance is generally 50% by mass or more, preferably 80% by mass or more, more preferably 90% by mass or more, and still more preferably 95% by mass or more, relative to the total mass of the raw material substance. When the aromatic compound having two or less nitro groups, which is an inexpensive non-explosive raw material, is contained at a high proportion, the content proportion of a compound having three or more nitro groups, which is an expensive low-explosive raw material, can be reduced. Therefore, most preferably, the content proportion of the aromatic compound having two or less nitro groups is 100% by mass as the upper limit thereof. However, the upper limit thereof may be preferably about 99% by mass or about 98% by mass.

The detonation velocity of the explosive substance disposed in the periphery of the aforementioned raw material substance must be made higher than the detonation velocity of the raw material substance. That is, of the aromatic compound having two or less nitro groups and contained in the raw material substance, for example, dinitrotoluene (DNT, true density: 1.52 g/cm³, melting point: 67 to 70°C) that is inexpensive and easy to use is so stable that it cannot be detonated easily. However, the detonation velocity thereof can be estimated as about 6,000 m/sec if it can be detonated. It is therefore necessary to make the detonation velocity of the explosive substance not lower than this viscosity. The detonation velocity of a typical explosive substance is generally 10,000 m/sec or lower. In the present invention, therefore, the detonation velocity of the explosive substance is 6,300 m/sec or higher, and as the upper limit thereof, it is preferably 10,000 m/sec or lower. As for the detonation velocity of DNT, it is possible to refer to Combustion and Flames, Vol. 14 (1970), pp. 145.

The detonation velocity means a propagation velocity of detonation when the detonation is caused by an explosive substance.

Of such explosive substances, examples of solid ones may include TNT, RDX, HMX, PETN, tetryl, an explosive mixture (for example, Composition B) having RDX and TNT as its major components, an explosive mixture (for example, Octol) having HMX and TNT as its major components, etc.

A liquid high explosive may be also used as the explosive substance. When the liquid high explosive is used as the explosive substance, the degree of freedom in shape is high, an increase in size is easy, and operability or safety can be improved, as compared with the case of using a solid high explosive. Examples of such liquid high explosives may include a mixture of hydrazine (including hydrazine hydrate that is a hydrate thereof) and hydrazine nitrate, a mixture of hydrazine and ammonium nitrate, a mixture of hydrazine, hydrazine nitrate and ammonium nitrate, nitromethane, a mixture of hydrazine and nitromethane, and the like.

Of the aforementioned explosive substances, TNT easy to be molded, Composition B containing TNT as its major component, or the like, is preferred as solid one due to a low melting point. Each of the aforementioned explosive substances may be used alone, or two or more kinds of the explosive substances may be used together. Properties and detonation velocities of typical explosive substances are shown in the following Table 1. The explosive substances capable of causing stable detonation are shown in the following Table 1.

**Table 1**

| Explosive substance | Molecular formula | Density¹⁾ (g/cm³) | Detonation velocity (m/s) | Melting point (°C) |
|---|---|---|---|---|
| TNT | C₇H₅N₃O₆ | 1.64 | 6940 | 80.9 |
| RDX | C₃H₆N₆O₆ | 1.77 | 8640 | 204.1 |
| HMX | C₄H₈N₈O₈ | 1.89 | 9110 | 278.0 |
| PETN | C₅H₈N₄O₁₂ | 1.67 | 7980 | 142.9 |
| Tetryl | C₇H₅N₈O₈ | 1.68 | 7670 | 129.4 |
| Composition B²⁾ | - | 1.71 | 8020 | 80.1 |
| Octol (75/25)³⁾ | - | 1.81 | 8450 | 80.1 |
| Nitromethane | CH₃NO₂ | 1.13 | 6260 | - |
| NH+HH⁴) | - | 1.39 | 8330 | - |

| | | | | |
|---|---|---|---|---|
| ¹⁾ Density at time of measurement of detonation velocity ²⁾ Explosive mixture of 59.5% by mass of RDX, 39.5% by mass of TNT and 1.0% by mass of wax ³⁾ Explosive mixture of 75% by mass of HMX and 25% by mass of TNT ⁴⁾ Hydrazine-based liquid high explosive in which hydrazine nitrate (H₂N-NH₂·HNO₃) and hydrazine hydrate (H₂N-NH₂·H₂O) are mixed at mass ratio of 3:1 | | | | |

The detonation velocity of nitromethane is based on Kusakabe and Fujiwara "Studies regarding Detonation of Liquid High Explosives (First Report)", Journal of the Industrial Explosives Society, Japan, Vol. 40, No. 2 (1979), p. 109. The detonation velocity of NH+HH (hydrazine nitrate (H₂N-NH₂·HNO₃) and hydrazine hydrate (H₂N-NH₂·H₂O)) is based on Kusakabe et al. "Studies regarding Detonation of Liquid High Explosives (Third Report)", Journal of the Industrial Explosives Society, Japan, Vol. 41, No. 1 (1980), p. 23. The detonation velocities of the other substances than nitromethane and NH+HH are based on LASL Explosive Properties Date, ed. Gibbs, T. R. and Propolato, A., University of California Press, Berkeley, Los Angels, London, 1980.

Use amounts of the aforementioned raw material substance and the aforementioned explosive substance may be adjusted individually and appropriately depending on a desired amount of carbon particles. Though not limited especially, the mass ratio of them (explosive substance/raw material substance) is preferably 0.1 or more, and more preferably 0.2 or more. In addition, the mass ratio is preferably 1 or less, more preferably 0.9 or less and still more preferably 0.8 or less. When the use amount ratio is lower than 0.1, it is impossible to cause enough detonation reaction to generate carbon particles. Thus, the yield may be reduced. On the contrary, when the use amount ratio exceeds 1, the explosive substance more than necessary is used. Thus, the production cost may increase.

The method for producing the carbon particles has been described above.

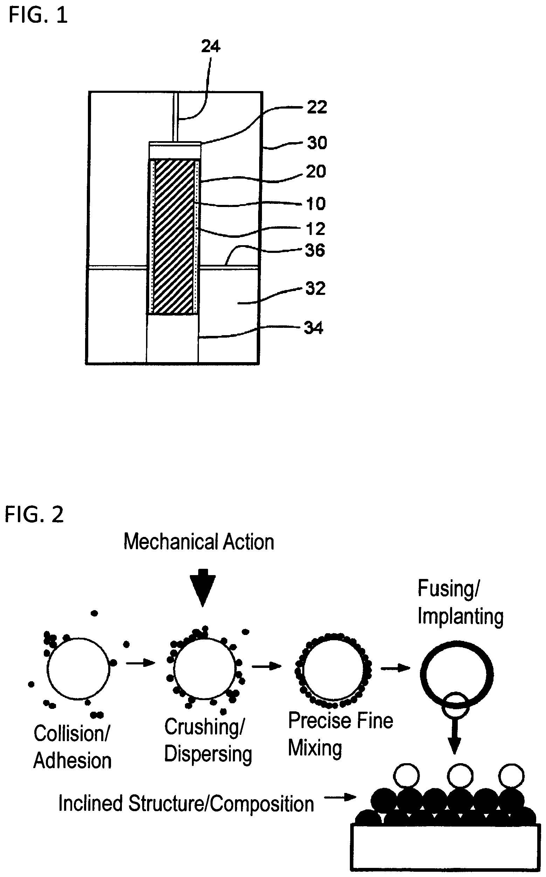

Next, embodiments for carrying out the method for producing the carbon particles will be described in detail with reference to the drawings. FIG. 1 is a sectional diagram schematically showing an example of an explosive device for use in the aforementioned production method. The explosive device shown in FIG. 1 is merely exemplary. It is not intended to limit the present invention.

First of all, an explosive substance 12 is disposed in a periphery of a raw material substance 10. When the explosive substance 12 is disposed in the periphery of the raw material substance 10, it is preferred to symmetrically dispose the raw material substance 10 and the explosive substance 12 in such a manner that high temperature and high pressure associated with a shock wave generated by detonation of the explosive substance 12 are applied to the raw material substance 10 as uniformly as possible, namely, in such a manner that the symmetry of an explosion shape is ensured. For example, in the case (a) where both the raw material substance 10 and the explosive substance 12 are solid, the raw material substance 10 and the explosive substance 12 may be melt-loaded or press-loaded in cylindrical split dies to prepare concentric columnar molded bodies. In the case (b) where the raw material substance 10 is solid and the explosive substance 12 is a liquid high explosive, the raw material substance 10 may be melt-loaded or press-loaded to prepare a columnar molded body, and the molded body may be placed in a center part of an inside of a cylindrical container while allowing axial directions thereof to agree with each other, and thereafter, the liquid high explosive may be injected in the periphery thereof. In the case (c) where the raw material substance 10 is liquid and the explosive substance 12 is solid, the explosive substance 12 may be melt-loaded or press-loaded in a concentric hollow columnar molded body and the liquid raw material substance 10 may be injected in a hollow part thereof. A container 20 housing the raw material substance 10 and the explosive substance 12 will be hereinafter referred to as an "explosion container". As the explosion container 20, it is preferred to use a container made of a synthetic resin such as an acrylic resin, because contamination with impurities such as metals can be prevented.

In the aforementioned production method, subsequently, the explosive substance 12 is detonated to form carbon particles from the raw material substance 10. The shock wave generated by the detonation reaction of the explosive substance 12 propagates towards the raw material substance 10, the raw material substance 10 is compressed by this shock wave to cause the detonation, and carbon atoms decomposed and liberated from organic molecules constituting the raw material substance 10 are changed to the carbon particles containing graphite carbon and nanodiamond.

The detonation may be performed in either an open system or a closed system. In order to perform the detonation in the open system, the detonation may be performed in, for example, an inside of an earthwork or a gallery provided by excavating the underground. The detonation in the closed system is preferably performed in a state where a chamber made of metal is filled with the raw material substance and the explosive substance. The state where a chamber made of metal is filled with the raw material substance and the explosive substance is, for example, a state where the molded body of the raw material substance and the explosive substance or the explosion container storing the raw material substance and the explosive substance is suspended in the chamber. It is preferred to perform the detonation in the closed system because a residue can be prevented from being scattered over a wide range. The chamber used for performing the detonation will be hereinafter referred to as an "explosion chamber". When the atmosphere in the explosion chamber is substantially free from oxygen on the occasion of the detonation, an oxidation reaction of the carbon fraction can be inhibited. Therefore, the yield can be improved. In order to obtain such an atmosphere, for example, a gas in the explosion chamber may be substituted with an inert gas such as a nitrogen gas, an argon gas or a carbon dioxide gas; the explosion chamber may be evacuated to about -0.1 to -0.01 MPaG (the symbol "G" attached after the pressure unit means that it is a gauge pressure; the same thing can be applied below); or after releasing the air (oxygen) from the explosion chamber by evacuation, such an inert gas may be injected into the explosion chamber to a weak positive pressure of about +0.000 to +0.001 MPaG. The chamber is not limited to a chamber made of metal as long as the chamber has strength high enough to endure the detonation. For example, the chamber may be made of concrete.

Further, it is preferred to dispose a coolant around the raw material substance and the explosive substance in the explosion chamber. When the coolant is disposed, the formed diamond can be rapidly cooled to prevent phase transition to the graphite carbon. In order to dispose the coolant, for example, the aforementioned molded body or the explosion container 20 may be placed in a cooling container 30, and a coolant 32 may be charged into a gap between the cooling container 30 and the molded body or the explosion container 20. Here, when the coolant 32 is a substance which can substantially prevent generation of an oxidative substance such as oxygen or ozone, the oxidation reaction of the carbon fraction can be inhibited. Therefore, the yield is improved. In order to obtain the coolant 32 like this, for example, an oxygen gas dissolved in the coolant 32 may be removed, or the coolant 32 which does not contain a constituent element producing any oxidative substance such as oxygen or ozone may be used. Examples of such coolants 32 may include water, halogenated alkyls (such as chlorofluorocarbons and carbon tetrachloride), and the like. Water is especially preferred because it has substantially no adverse affection on the environment.

Although the explosive substance 12 is generally blasted by using a detonator or a detonating cord, in order to more surely cause the detonation, a booster 22 may be allowed to intervene between the explosive substance 12 and the detonator or the detonating cord. In this case, after the booster 22 and the detonator or the detonating cord 24 are attached to the molded body or the explosion container 20, they are, for example, loaded in the explosion chamber. Examples of such boosters 22 may include Composition C-4, SEP manufactured by Asahi Kasei Chemicals Corporation, and the like.

When the coolant 32 is used, it is preferred that the aforementioned molded body or the explosion container 20 is housed in a fluid-tight container (for example, a bag using an olefinic synthetic resin such as polyethylene or polypropylene as a raw material) so that, for example, the coolant 32 cannot penetrate into the explosion container 20. After setting up in this way, when the explosive substance 12 is blasted to perform the detonation, the carbon particles containing graphite carbon and diamond are obtained as a residue thereof.

In the aforementioned production method, the residue obtained in the detonation step may possibly contain, as impurities, blasted wreckage such as a wreck of the container, a lead wire or a wire. In such a case, it is preferred to provide a step of removing the wreckage from the residue obtained in the detonation step to recover the carbon particles. In this step for recovering the carbon particles, for example, when classification/purification processing is performed, the carbon particles can be obtained in a form of dry powder having a desired particle size. Typically, first of all, after removing rough wreckage from the residue obtained in the detonation step, the resultant is classified with a sieve or the like and separated into a sieve-passing material and a residue on the sieve, and the sieve-passing material is recovered. The residue on the sieve may be crushed and then classified again. Water is separated from the finally obtained sieve-passing material to prepare a dry powder. Here, an opening of the sieve is properly adjusted, and the classification/purification processing is repeated. Then, the sieve-passing material of the sieve having an opening corresponding to a desired particle size may be obtained as a product. In more detail, for example, when the detonation is performed in the explosion chamber using water as the coolant 32, residue-containing water is recovered, followed by sedimentation separation. After removing rough wreckage, a supernatant is recovered as a waste fluid, and a precipitate is classified with a sieve or the like to obtain a sieve-passing material. A part of formed carbon components may possibly attach to the wreckage. Therefore, a residue on the sieve is crushed and separated by means of ultrasonic vibration or the like and classified again with a sieve or the like. For example, a residue on a sieve having an opening of about 100 µm is mostly blasted wreckage such as a wreck of the explosion container 20, a lead wire or a wire. Therefore, such a residue on the sieve is disposed as an industrial waste after recovery. Of the particles passing through a sieve having an opening of about 100 µm, a residue on a sieve having an opening of about 32 µm may be crushed and separated by means of ultrasonic vibration or the like and classified again with a sieve or the like. It is preferred to recover the sieve-passing material of the sieve having the opening of about 32 µm as a final product through these operations. As for the recovered product, water is separated by means of centrifugation or the like, and then dried to obtain a powder of carbon particles having a desired particle size.

For example, when a container made of an acrylic resin is used as the explosion container 20, the residue obtained in the detonation step may possibly be contaminated with particles or powder of the acrylic resin. In this case, the acrylic resin may be removed by, for example, an elution treatment of the acrylic resin with acetone.

Further, in some application, contamination with a metal such as iron is sometimes undesirable. In such a case, for example, the metal such as iron may be removed by treatment with hot concentrated nitric acid.

The obtained powder is nano-scale carbon particles containing plenty of graphite carbon as well as nanodiamond. However, in some application, it is required to make good use of excellent properties of diamond.

In the carbon particles obtained by the aforementioned production method, the mass ratio G/D is 2.5 or more when G designates the mass of graphite carbon and D designates the mass of diamond. The composition and physical properties of the carbon particles for use in the present invention will be described below in detail.

The carbon particles for use in the present invention can be defined by the content proportion of a carbon component expressed by mass ratio. As described above, the raw material substance causes detonation, whereby the raw material substance is decomposed to an atomic level, and carbon atoms liberated therefrom without being oxidized aggregate in a solid state to form carbon particles. During the detonation, the raw material substance is in a high-temperature high-pressure state due to a decomposition reaction. However, the raw material substance is immediately expanded and cooled. This process from the high-temperature high-pressure state to the reduced-pressure and cooling state is caused within a very short time as compared with normal combustion or deflagration that is an explosion phenomenon slower than the detonation, and therefore, there is no time when the aggregated carbon grows largely. Thus, the nano-scale carbon particles are formed.

When a high explosive such as the aforementioned RDX or HMX known as a typical high explosive causing detonation is used as the raw material substance, pressure during the detonation becomes high enough to allow produced carbon particles to contain plenty of nanodiamond as expected easily from a thermodynamic equilibrium phase diagram of carbon. On the other hand, when a non-high explosive is used as the raw material substance, the pressure during the detonation is not high enough to synthesize diamond. Thus, nano-scale carbon particles other than diamond are produced. The carbon particles contain plenty of nano-scale graphite carbon.

In this manner, the content proportion between nanodiamond and nanographite can be controlled by pressure during detonation of a raw material substance. That is, by use of a raw material substance that is not a high explosive, the content proportion of nanographite can be increased. However, when the pressure during detonation of the raw material substance is lower than that of a high explosive, it is difficult to detonate the raw material substance, or even if the raw material substance can be detonated, it is likely to cause a phenomenon that the detonation may be interrupted. This suggests that it is difficult to stably detonate the raw material substance alone. Therefore, when the pressure during detonation of the raw material substance is low, an explosive substance causing detonation has to be disposed in the periphery of the raw material substance to thereby contrive to surely detonate the raw material substance. In addition, in any case, it is important to select a raw material substance having a composition that does not oxidize the liberated carbon.

Further, it is preferable that an oxidative substance such as oxygen or ozone that can oxidize the liberated carbon to form gas such as CO or CO₂ is removed from a detonation system as much as possible.

In addition, when a raw material substance containing low explosives or an aromatic compound having two or less nitro groups is detonated, it is assumed that any kinds of nano-scale carbon particles such as diamond, graphite, fine carbon nanotube, fulleren, etc. are produced.

From literatures (Satoshi Tomita et al., "Diamond nanoparticles to carbon onions transformation: X-ray diffraction studies", Carbon 40, pp. 1469-1474 (2002), Dilip K. Singh et al, "Diameter dependence of interwall separation and strain in multiwalled carbon nanotubes probed by X-ray diffraction and Raman scattering studies", Diamond & Related Materials 19, pp.1281-1288 (2010), etc.) and the results of X-ray diffraction data of detonation nanodiamond acquired so far as described below, it may be assumed that a peak in which a diffraction angle 2θ of the X-ray diffraction data measured by a Cu(Kα) tube is near 24 to 26° (hereinafter referred to as "peak near 26°") is originated from a nanocarbon substance composed mainly of a laminate sp2 carbon structure. In addition, with respect to (multilayer) carbon nanotubes of two layers, three layers or the like, a peak appears in this region.

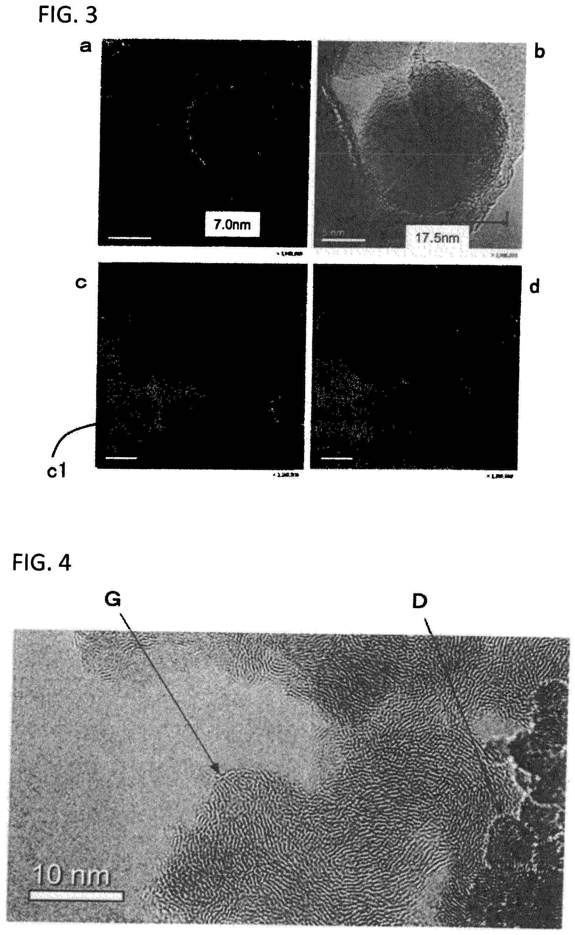

The results of observation of a lattice image in a transmission electron microscopic (TEM) photograph of carbon particles obtained in Experimental Example 3 as described later are shown in FIG. 4. In FIG. 4, two kinds of shapes of lattice images were observed. That is, a round spherical shape and a laminated shape (graphite) were observed as shown by the symbols D and G respectively. Both of them are of a nano-scale, and in view of the existent amounts thereof, the both are assumed as particles having carbon as a main component. Since the particles of carbon observed herein are assumed to be nanodiamond and graphite carbon, their lattice spacing and plane interval of lamination were measured and compared. As for a scale bar (5 nm and 10 nm) and a magnification of TEM, a sample in which an SiGe multilayered film is attached to an Si single crystal is used as a standard sample, and at a high magnification, calibration is made on the basis of an Si 111 plane interval of 3.1355 Å. This calibration operation has been confirmed to be within 5% by an accuracy management of every month.

In the diamond (symbol D) taken in the same field of FIG. 4, a D 111 plane was observed, and the result of the measured lattice spacing was 2.11 Å. It is generally said that the D 111 plane lattice spacing in cubic diamond is 2.06 Å by powder diffractometry, and the difference ratio therefrom is 2.4%. On the other hand, the result of the plane interval of lamination observed in the part shown by the symbol G in FIG. 4 was 3.46 Å. It is said that the G 002 plane interval in the lamination of hexagonal graphite is 3.37 Å by powder diffractometry, and the difference ratio therefrom is 2.4%. Thus, the observed plane interval of the lamination substantially agreed with the plane interval of lamination of graphite. It is therefore considered that the laminated nano-scale carbon particles are of graphite, occupying a major proportion of the carbon particles.

In the X-ray diffraction data, nanodiamond can be confirmed. However, as for the nano-scale carbon particles, it is not clear what kind of substance is contained other than nanographite and fine multilayer carbon nanotube providing the peak near 26°. Fine monolayer (single) carbon nanotubes or various fullerenes do not take part in the peak near 26°. Therefore, their production amount is not included in the quantitative result based on the peak near 26°. Further, it can be, for example, assumed that nano-scale carbon particles whose laminated (graphite) structure has been changed to a turbostratic structure are also included in the peak near 26°. It cannot be denied that mixture of peaks of those deformed nano-scale carbon particles may act to expand the width of the peak near 26°. However, from the TEM photograph, it has been found that the production amount of fine monolayer (single) carbon nanotubes, various fullerenes, etc. is small. That is, when carbon particles are produced by a detonation method, it is assumed that the production amount of nano-scale carbon particles that are not expressed by the peak near 26° can fall within a certain proportion range of a low mass ratio. It is therefore assumed that a large error is not provided even when all the carbon other than diamond is regarded as graphite carbon. Further, it is assumed that carbon with another structure is rare.

From the aforementioned background, it is assumed that if kinds, amounts and configurations of a raw material substance and an explosive substance are determined in a specified production method, nanodiamond and nanographite produced by the production method can fall within a certain proportion range of a mass ratio. It is therefore assumed that a large error is not provided even when all the carbon other than diamond is regarded as graphite carbon. Accordingly, it is assumed that carbon with another structure than diamond and graphite carbon is rare. Thus, on the assumption that carbon other than diamond is graphite carbon, the ratio between them is obtained.

From the aforementioned background, in the present invention, uses is made of carbon particles containing graphite carbon and diamond and having the feature that the content proportion of graphite carbon is higher than that in a conventional product obtained by use of a low explosive raw material. More specifically, when G designates the mass of graphite carbon and D designates the mass of diamond, the mass ratio G/D is 2.5 or more, preferably 3 or more, more preferably 3.5 or more, and still more preferably 4 or more. The upper limit of the mass ratio G/D is not limited especially. When it is taken into consideration that diamond is contained, the mass ratio G/D is preferably 100 or less, more preferably 50 or less, and still more preferably 20 or less. The mass ratio G/D is obtained by a method that will be described in the following examples.

The coated particles in the present invention has a configuration in which surfaces of base material particles are coated with carbon particles obtained by the aforementioned production method. When the surfaces of the base material particles are coated with the aforementioned carbon particles, the coated particles can be used as a new raw material in various applications.

In the coated particles, the surfaces of the base material particles may be coated with the carbon particles so that the film thickness reaches 0.004 µm. That is, when the carbon particles are applied to be thinnest, the film thickness may be 0.004 µm. The film thickness may be 1 µm or more. The upper limit of the film thickness is not limited especially. For example, the film thickness is 10 µm or less.

The kind of the base material particles is not limited especially. Examples of the base material particles may include carbon, resin, glass, ceramics, metal, natural raw materials, etc. Examples of carbon may include artificial graphite. Examples of resins may include acrylic, urethane, nylon, polyethylene, high molecular weight polyethylene, polytetrafluoroethylene, etc. Examples of glasses may include various amorphous glasses, crystallized glasses, etc. Examples of ceramics may include SiC, inactive alumina, silica, titania, zirconia, etc. Examples of metals may include aluminum, pure copper, bronze, brass, carbon steel, stainless streel, maraging steel, nickel-base alloys, etc. In addition, synthetic zeolite, natural raw materials such as wood chips, minerals, coals and rocks, etc. may be used.

The size of the base material particles is not limited especially. For example, the base material particles may have a size of about 2 to 550 µm.

It is preferred that the surfaces of the base material particles are perfectly covered and coated with the carbon particles. However, the present invention is not limited thereto. The carbon particles may adhere to only a part of the surfaces of the base material particles.

The coated particles can be produced by a method including a step of disposing an explosive substance with a detonation velocity of 6,300 m/sec or higher in a periphery of a raw material substance containing an aromatic compound having two or less nitro groups, a step of detonating the explosive substance, and a step of coating surfaces of base material particles with the obtained carbon particles by a mechanical combination method.

The mechanical combination method means mixing or crushing. That is, due to a relation between functional expression of particles and energy applied thereto during mechanical powder processing, not only simple positional replacement (mixing) but also advanced functionality addition such as uniform dispersing, refining (crushing) and surface coating (combining) are attained on the particle side as the applied energy increases.

When a mechanical shearing/impacting action is applied to a mixture of powders whose particle sizes are largely different, particle surfaces become amorphous, and activities on the surfaces are enhanced. When there are different kinds of powders in one system, composite particles whose surfaces are coated with fine particles having smaller particle sizes are produced due to interaction of the powders. The surface of each of particles (referred to as core particles or mother particles) serving as cores of the combination has a regular structure similarly. Therefore, this particle combination is also referred to as "regular mixing" or "precise fine mixing".

In a state where the mechanical energy is further high, a solid-solid reaction or a mechanochemical reaction appears. That is, an interaction occurs on a scale corresponding to the applied energy, and an interaction on a molecular/atomic level appears in higher energy.

Generally, composite particles take the following two forms. One form is a coated composite particle in which a surface of a core particle is covered with a very fine particle (child particle), and the other form is a distributed composite particle in which a child particle enters the inside of a core particle or the child particle and the core particle form a structure where they are entangled with each other. A capsule composite particle is of a core-shell type. What composite particles are produced depends on physical and chemical properties of core particles and child particles, and also depends on the magnitude of the mechanical action applied for the combination or the atmosphere.

As shown in FIG. 2, a process of mechanical combination includes (1) collision/adhesion of particles, (2) crushing/dispersing of the particles, (3) precise fine mixing of the particles, and (4) fusing/implanting of the particles. Those steps of the process are promoted by powerful impact, compression and shearing actions applied to the particles between a rotor or a ball rotating at a high speed and a container or an inner piece. Thus, the combination or the surface properties can be controlled.

Examples of combination apparatus may include a hybridization system (high-speed air flow impact method), a mechano-fusion system, and the like. Those combination apparatus have different mechanical actions, respectively. For example, in the hybridization system, due to collision with a blade or a casing, very powerful impact is applied to particles so that different substances can be implanted or fused. In addition, the mechano-fusion system can be also expected to be applied to mechanical alloying because of actions of powerful compressing force and powerful shearing force. On the other hand, in some cases, such powerful mechanical actions may inhibit the function expression in the composite particles. For example, deterioration in function or a change in crystal structure may be caused by sudden temperature rise or shock. Against such cases, it has also been developed a relatively mild approach. The approach is attained by a stirring mixer such as a Henschel mixer in which fine particles can be well dispersed by rotation of a stirring blade. It is convenient to the purpose of precise fine mixing in the particle surfaces. Further, there is another approach using a θ-composer that can firmly fix a substance without changing a structure thereof, that is, can be expected to have a so-called intermediate mechanical action. Examples that will be described later use an "MP5 type mixer (compositor)" apparatus made by NIPPON COKE & ENGINEERING Co., Ltd., which is an improvement of the aforementioned Henschel mixer to have a function similar to the hybridization system. However, the coated particles in the present invention are not intended to be obtained only by the apparatus, but it can be obtained by the aforementioned various mechanical combination methods in the same manner.

In the present invention, the carbon particles may be fluorinated, and then, the surfaces of the base material particles may be coated with the carbon particles. When the carbon particles are fluorinated in advance, functions of fluorine itself, such as water repellency, oil repellency, releasability, non-adhesiveness, antifouling property, chemical resistance, lubricity, antibacterial property, oxidizability, etc. can be given to the coated particles. In addition, the coated particles can be dispersed easily in both of water and an organic solvent.

As for the aforementioned fluorination treatment, for example, a direct fluorination method for making the base material particles react with fluorine gas or a fluorinating agent derived from fluorine gas can be used. In addition, a method for fluorinating the base material particles due to reaction with fluorine plasma may be used. Further, a method for fluorinating the base material particles in a solution by a fluorinating agent such as a fluoroalkyl group-containing oligomer may be used. Furthermore, fluorination with a fluorinating agent in an ionic liquid may be used.

Attention has been paid to graphite fluoride as a new industrial material due to its chemical and physical properties. Graphite fluoride is a white powder-like inorganic sheet polymer produced by direct reaction of carbon with fluorine. Although graphite fluoride is apt to be identified with fluorocarbon such as CF₄, C₂F₆ or {CF₂-CF₂}ₙ, graphite fluoride has the features that: graphite fluoride produced from graphite becomes crystalline; graphite fluoride is a solid polymer that cannot be synthesized by means of polycondensation or the like; and so on. Therefore, it is referred to as graphite fluoride in distinction from general compounds of carbon and fluorine. Such carbon materials form a system to be dealt with as substances in a boundary region between organic chemistry and inorganic chemistry because of their production histories and so on.

It has been heretofore considered that graphite fluoride produced from various carbon raw materials such as amorphous carbon, carbon black, petroleum coke, graphite, etc. can be expressed by (CF)ₙ. However, in the graphite fluoride in the present invention, a C-F bond is most popular, but a C-F₂ bond and a C-F₃ bond are also recognized, as will be described later.

The coated particles contain graphite carbon and diamond in the surfaces of the base material particles. Therefore, using excellent properties of diamond such as grindability, durability, wear resistance, etc., the coated particles are useful for application as a wear resistant agent, a lubricant, etc. In addition, using excellent properties of graphite carbon such as electric conductivity, water repellency, biocompatibility, etc., the coated particles are useful for application as a fiber material, a resin coating for providing functionality, a drug delivery system, an electronic device cover, an electrode material for a battery, a conductive film, a reinforced rubber/water-repellent rubber, a catalyst, an adsorption material, etc.

The present invention also includes a functional material in which the aforementioned coated particles are supported on a surface of a substrate material. When the coated particles are supported, the following effects can be obtained. That is, depending on the kind of the substrate material supporting the coated particles, the surface hardness of the substrate material can be increased; the friction coefficient can be lowered to improve lubricity; the wear resistance can be improved; the catalytic property (reaction activity) can be improved; the electric conductivity can be improved; the thermal conductivity can be improved; the antifouling property can be improved; or if the coated particles are fluorinated, the water repellency, the oil repellency, the releasability, the non-adhesiveness, the antifouling property, the chemical resistance, the lubricity, the antibacterial property or the oxidizability can be improved.

The substrate material supporting the coated particles is not limited especially. Examples of such substrate materials may include carbon, wood, glass, resin, ceramics, metal, concrete, exterior wall materials, etc.

Examples of such carbons may include graphite, glassy carbon, artificial graphite, isotropic graphite, carbon black, fine carbon, C/C composite (carbon fiber reinforced carbon composite), carbon fiber, etc.

Examples of such glasses may include Pyrex (registered trademark) glass, amorphous glass such as quartz glass, crystallized glass such as lithium aluminosilicate glass or magnesium aluminosilicate glass, special glass such as conductive glass, etc.

Examples of such resins may include thermoplastic resin, thermosetting resin, nylon, engineering plastic, etc. Examples of such thermoplastic resins may include polyethylene, polypropylene, polyvinylchloride, polystyrene, polyvinyl acetate, polyurethane, polytetrafluoroethylene, ABS resin, acrylic resin, polycarbonate, etc. Examples of such thermosetting resins may include phenolic resin, epoxy resin, polyester resin, etc. Examples of such engineering plastics may include polyacetal, bakelite, epoxy glass, ultra-high molecular weight polyethylene, polyamide, modified polyphenylene ether, polyethylene terephthalate, polybutylene terephthalate, polyphenylene sulfide, polyarylate, polyamideimide, polyether imide, polyether ketone, polyether ether ketone, polysulfone, polyether sulfone, fluoropolymer, etc.

Examples of such ceramics may include oxide ceramics such as alumina, silica and quartz, carbide ceramics such as silicon carbide, nitride ceramics such as silicon nitride and aluminum nitride, titania, zirconia, etc.

Examples of such metals may include iron-based metals such as ordinary steel, tool steel, bearing steel, stainless steel, iron and cast iron, nonferrous metals such as copper, copper alloys, aluminum, aluminum alloys, nickel, nickel-based alloys, tin, lead, cobalt, titanium, chromium, gold, silver, platinum, palladium, magnesium, manganese and zinc, etc. Further, alloys of those metals may be used, or oxides of the metals may be also used.

The shape of the substrate material is not limited especially. Examples of such shapes may include a sheet-like shape, a columnar shape, a cylindrical shape, etc.

The functional material can be produced by supporting the coated particles on the surface of the substrate material.

As a method for supporting the coated particles on the surface of the substrate material, for example, (1) thermal spraying, (2) rolling, (3) plating, etc. can be used. (1) Thermal spraying and (2) rolling can be collectively referred to as a thermomechanical processing method. Further, a particle collision method using a mechanism in which heat is generated by high-speed collision of fine particles (also referred to as WPC (Wide Peening Cleaning) by some people) may be used.

### (1) Thermal Spraying

The functional material supporting the coated particles on the surface of the substrate material can be produced by thermal-spraying the coated particles against the substrate material.

A thermal spraying method is a kind of surface modification technique in which a material to be thermal-sprayed, such as metal or ceramics, is heated to a molten or semi-molten state by use of combustion flame, electric energy or the like, and material particles obtained thus are thermal-sprayed against a surface of a substrate material so as to form a coating on the surface of the substrate material. Combustion gas, plasma or the like is used as a heat source for melting the material to be thermal-sprayed such as powder or a wire. The molten material is formed into fine particles each having a diameter of several µm to one hundred and several tens of µm. The fine particles collide with the surface of the substrate material at a high speed of several tens of m/sec to several hundreds of m/sec. Thus, a coating is formed by lamination of flat fine particles solidified rapidly (10⁷°C/sec or higher in a case of liquefied metal particles). This lamination structure is a conspicuous feature of a thermal-sprayed coating, and it is also referred to as lamellar structure. This structure has been used for applications as follows. That is, materials to be thermal-sprayed are thermal-sprayed against surfaces of members in various instruments or devices to add thereto functions and qualities including wear resistance, corrosion resistance, thermal insulation, electric conductivity, etc. separately from raw materials of the members. There are a large number of methods and processes for thermal spraying.

The thermal spraying method is not limited especially. Examples of such methods may include flame spraying, arc spraying, plasma spraying, detonation spraying, high speed flame spraying, cold spraying, etc. The flame spraying, the arc spraying and the plasma spraying are known as temperature-based spraying methods in which particles melted satisfactorily are sprayed at a low speed. On the other hand, the detonation spraying, the high speed flame spraying and the cold spraying are known as speed-based spraying methods in which semi-molten particles are sprayed at a high speed. Of them, the cold spraying is one of surface coating techniques based on high-speed fine particle collision and has the main feature that particles are accelerated by low-temperature and high-speed working gas. Since the temperature of the gas is lower than the melting point of material particles, the material particles are not melted. Therefore, in recent years, the cold spraying has been also used for thermal-spraying nanocarbon materials such as carbon nanotubes. However, nano-sized carbon particles forming a part of coated particles are obtained by a detonation method in the present invention. The carbon particles are exposed to a high temperature of 800°C or higher when the carbon particles are produced. It is therefore assumed that the carbon particles have higher heat resistance than any other nanocarbon material such as carbon nanotube. Thus, when metal or ceramic that is a heat-resistant material is selected for the base material particles, the base material particles can be dealt with even in a temperature-based spraying method. It can be considered that it is not necessary to limit the thermal-spraying method to a speed-based spraying method.

It can be considered that when the coated particles in the present invention are subjected to thermal spraying by various methods, wear resistance, slidability, electric conductivity (in a case where the substrate material is ceramic or resin), etc. can be improved by the carbon particles existing in the thermal-sprayed coating. Further, more functions can be expected when the carbon particles in the thermal-sprayed coating are regarded as a catalyst or a carrier, or a filler serving as a binder. That is, when the carbon particles supported in the coated particles are changed to graphite fluoride by the aforementioned fluorination, functions such as water repellency, oil repellency, releasability, non-adhesiveness, antifouling property, chemical resistance, lubricity, antibacterial property, oxidizability, etc. can be given to the coated particles. When the carbon particles in the thermal-sprayed coated particles are fluorinated in the same manner, functions of graphite fluoride can be given to the thermal-sprayed surface of the substrate material in the same manner as the fluorinated coated particles. That is, when the thermal-sprayed surface of the substrate surface is fluorinated, functions such as water repellency, oil repellency, releasability, non-adhesiveness, antifouling property, chemical resistance, lubricity, antibacterial property, oxidizability, etc. can be given to the surface of the substrate material.

### (2) Rolling

When the coated particles are rolled on the substrate material, a functional material supporting the coated particles in its surface can be produced.

The rolling method is not limited especially. Examples of such methods may include a press rolling method such as a roll press method or a belt press method, a forging method such as a batch-type flat hot press method, a clad rolling method, etc.

The rolling is not limited to a method in which only the coated particles are supplied and shaped, but a method in which a mixture of the coated particles and a binder agent is supplied and shaped may be used. When a combination of materials for the base material particles and the substrate material is selected, the coated particles can be supported on the surface of the substrate material without any adhesive. For example, metal, ceramic or the like with a high melting point is selected for the base material particles, and resin with a low melting point or the like is selected for the substrate material. When hot pressing is performed at a heating temperature slightly higher than the melting point of the lower melting side, the coated particles can be welded to the substrate material. On the contrary, the resin with a low melting point or the like may be selected for the base material particles and metal with a high melting point, ceramic with a high melting point may be selected for the substrate material. When hot pressing is performed at a heating temperature slightly higher than the melting point of the lower melting side in the same manner, the base material particles of the coated particles are melted and spread onto the surface of the substrate material. After being cooled, a layered base material coating including the carbon particles can be formed in the surface of the substrate material. Alternatively, alumina, SiC, stainless steel, maraging steel, tool steel or the like which has high hardness may be selected for the base material particles, and one of various resins, aluminum, copper or the like which has low hardness may be selected for the substrate material. In this case, the coated particles can be supported on the surface of the substrate material even by rolling at a low heating temperature.

In an example in which the coated particles are mixed with a binder agent and subjected to clad rolling, extrusion or the like, there is a case where the binder agent cannot be uniformly dissolved easily in a combination of aluminum and boron powder. In this case, a clad rolled sheet to which aluminum is fused in a high compacted state can be obtained by a method in which a powder mixture of boride powder and aluminum alloy powder is directly extruded, a method in which a preformed body of the powder mixture preformed into a predetermined shape is extruded, forged or rolled, and a method in which the powder mixture and the preformed body is enclosed by a metal container having a predetermined shape, and extruded, forged or rolled. On the other hand, in the present invention, the binder agent is not limited to aluminum or aluminum alloy power. Thermosetting resin or reactive hot melt adhesive, which is often used for producing plywood (veneer), may be used. Thus, it can be considered that when the coated particles in the present invention is rolled by various methods, wear resistance, slidability, electric conductivity (in a case where the substrate material is ceramic or resin), etc. can be improved by the carbon particles existing in the thermal-sprayed coating.

Further, more functions can be expected when the carbon particles are regarded as a catalyst or a carrier, or a filler serving as a binder.

As the coated particles, as described above, coated particles in which the surfaces of the base material particles are coated with the fluorinated carbon particles may be used. Alternatively, coated particles in which the surfaces of the base material particles are coated with the carbon particles that have not been fluorinated yet may be prepared, and fluorination treatment may be performed on the coated particles which have been supported on the surface of the substrate material.

### (3) Plating

When the substrate material is immersed and plated in a plating bath in which the coated particles have been dispersed, a functional material in which the coated particles are supported on the surface of the substrate material can be produced.

A plating method is not limited especially. For example, either electroplating or electroless (chemical) plating may be used. The kind of metal to be plated may be a single metal (such as copper, nickel, chromium, tin, zinc, silver, gold, etc.) or an alloy (such as brass, bronze, solder, Zn-Ni alloy, Zn-Fe alloy, Ni-P, Ni-B, Ni-W, Ni-Fe, etc.), serving as a composite plating method in which fine particles including the coated particles are deposited on the plated metal.

The plating bath is not limited especially as long as the coated particles have been dispersed in the plating bath. For example, it is possible to use a commercially available plating bath in which the coated particles have been dispersed.

The kind of plating bath is not limited especially. Examples of such plating baths may include an Ni plating bath, an Ni-P plating bath, an Ni-B plating bath, an Ni-W plating bath, an Ni-Cu-P plating bath, an Ni-S plating bath, a Cr-W plating bath, a Cr-Mo plating bath, a Cr-Fe plating bath, a Cr-C plating bath, a Cr-H plating bath, an Fe-W plating bath, an Fe-Mo plating bath, an Fe-Ni plating bath, a Co-W-based plating bath, a nickel sulfamate plating bath, a copper cyanide plating bath, a copper pyrophosphate plating bath, a copper sulfate plating bath, a hexavalent chromium plating bath, a zinc cyanide plating bath, a cyanide-free zinc plating bath, an alkaline tin plating bath, an acidic tin plating bath, a silver plating bath, a gold cyanide plating bath, an acidic gold plating bath, etc. Further, examples of such Ni plating baths may include a Watts bath, a sulfamic acid bath, a strike bath (Woods bath), a black nickel plating bath, etc.

The temperature of the plating bath during the plating is not limited especially. For example, it may be set at 50 to 90°C. Further, a plating solution may be stirred during the plating.

The present application claims benefits of the right of priority based on Japanese Patent Application No. 2015-133153, filed on July 1, 2015. The entire contents of the description of the aforementioned Japanese Patent Application No. 2015-133153 is incorporated herein by reference.

### Examples

The present invention will be described below along its examples more specifically. However, the present invention is not intended to be restricted by the following examples, and can be carried out with changes within a scope adaptable to the spirit of the present invention which has been described above and which will be described below. Any of those changes is also encompassed in the technical scope of the present invention.

Surfaces of base material particles were coated with carbon particles produced in procedures described in the following Experimental Examples 1 to 5, thereby producing coated particles.

### <<Experimental Example 1>>

In this experimental example, carbon particles were produced by a detonation method using dinitrotoluene (DNT) as a raw material substance and using a hydrazine-based liquid high explosive as an explosive substance. More specifically, DNT (industrial grade) was melted and loaded as a raw material substance, and formed into a columnar shape having a diameter of 10 cm and a height of 48 cm. A molded body obtained thus had a mass of 5.52 kg, a volume of 3,770 cm³, and a density of 1.46 g/cm³. In addition, a 75% hydrazine hydrate solution of hydrazine nitrate was subdivided by 2.50kg and prepared as an explosive substance.

Subsequently, a detonation reaction was performed by using the explosive device as illustrated in FIG. 1. The aforementioned molded body as the raw material substance 10 was placed in the center part of the explosion container 20 having an inside diameter of 12 cm and a height of 50 cm, and the aforementioned liquid high explosive as the explosive substance 12 was filled in the periphery thereof. The booster 22 (SEP), the detonating cord and the No. 6 electric detonator 24 were installed in a top of the explosion container 20, and covered with a lid. After that, the container was housed in a fluid-tight polyethylene bag. A container having a capacity of 100 L was used as the cooling container 30. The explosion container 20 was placed in the cooling container 30. Here, an outer bottom surface of the explosion container 20 was adjusted so as to be positioned at a height of 15 cm from an inner bottom surface of the cooling container 30, using an iron-made stand 34 and an iron-made perforated disk 36. Then, 120 L of distilled water was poured as the coolant 32 in the cooling container 30 and the polyethylene bag so that a gap between the cooling container 30 and the explosion container 20 could be filled with the coolant 32. After being covered with a lid, the cooling container 30 was suspended in an explosion chamber having an internal volume of 30 m³ from a ceiling thereof by using a wire sling. An inside of the aforementioned explosion chamber was evacuated from the atmospheric pressure to adjust the amount of a residual oxygen gas in the explosion chamber to about 279.9 g as calculated value.

After setting up in this way, the aforementioned detonating cord was blasted by the aforementioned detonator, thereby detonating the explosive substance 12. Then, about 120 L of water containing a residue was recovered from the inside of the aforementioned explosion chamber, and rough wreckage was removed by sedimentation separation. Here, since a supernatant was strongly alkaline, citric acid was added thereto to make the pH thereof weakly acidic. The supernatant made weakly acidic was recovered as a waste fluid as it was. A precipitate was classified with sieves having an opening of 100 µm and an opening of 16 µm respectively, using a vibration sieve device ("KG-700-2W" manufactured by Kowa Kogyosho Co., Ltd.). A 16 µm-sieve-passing material was recovered as it was. In Experimental Examples 2 to 5, which will be described later, classification was performed with sieves having an opening of 100 µm and an opening of 32 µm respectively, and a 32 µm-sieve-passing material was recovered as it was.

In Experimental Example 1, of a 100 µm-sieve-passing material, a residue on the sieve having the opening of 16 µm was crushed for about 5 minutes by an ultrasonic vibration device ("4G-250-3-TSA" manufactured by Crest). In each of Experimental Examples 2 to 5, of a 100 µm-sieve-passing material, a residue on the sieve having the opening of 32 µm was crushed in the same manner. A carbon fraction was separated from a wreckage surface and thereafter classified again with sieves having an opening of 100 µm, an opening of 32 µm and an opening of 16 µm respectively, using the vibration sieve device ("KG-700-2W" manufactured by Kowa Kogyosho Co., Ltd.). Sieve-passing materials were recovered. Each of the sieve-passing materials was allowed to stand in a drying machine ("OF-450S" manufactured by AS ONE Corporation) at 80°C for 24 hours to evaporate moisture, thereby preparing a dry powder thereof.

Thus, 2,048 g in total of carbon particles including 584 g of a 16 µm-sieve-passing material, 907 g of a 32 µm-sieve-passing material and 557 g of a 100 µm-sieve-passing material were obtained. The experiment contents, the recovery amount and yield of the carbon particles in this Experimental Example are shown in the following

Table 2.

### «Experimental Example 2»

In this Experimental Example, carbon particles were produced in the same manner as in the aforementioned Experimental Example 1, except that the use amount of the hydrazine-based liquid high explosive as the explosive substance was changed from 2.50 kg to 2.49 kg; the container having a capacity of 100 L as the cooling container was changed to a container having a capacity of 200 L; and the use amount of the distilled water as the coolant was changed from 120 L to 220 L. As a result, 2,334 g in total of carbon particles including 534 g of a 16 µm-sieve-passing material, 1,315 g of a 32 µm-sieve-passing material and 485 g of a 100 µm-sieve-passing material were obtained. The experiment contents, the recovery amount and yield of the carbon particles in this Experimental Example are shown in the following Table 2.

### «Experimental Example 3»

In this Experimental Example, carbon particles were produced in the same manner as in the aforementioned Experimental Example 1, except that the DNT as the raw material substance was changed from 5.52 kg to 5.46 kg in use amount and from 3,770 cm³ to 3,750 cm³ in volume; the container having a capacity of 100 L as the cooling container was changed to a container having a capacity of 200 L; the use amount of the distilled water as the coolant was changed from 120 L to 220 L; the amount (calculated value) of the residual oxygen gas in the chamber was changed from 279.9 g to 191.0 g; and citric acid was not added to the supernatant. As a result, 1,645 g in total of carbon particles including 164 g of a 16 µm-sieve-passing material, 801 g of a 32 µm-sieve-passing material and 680 g of a 100 µm-sieve-passing material were obtained. The experiment contents, the recovery amount and yield of the carbon particles in this Experimental Example are shown in the following Table 2.

### «Experimental Example 4»

In this experimental example, carbon particles were produced by a detonation method using 2,4-dinitrotoluene (2,4-DNT) as a raw material substance and using a hydrazine-based liquid high explosive as an explosive substance. More specifically, 2,4-DNT (industrial grade) was melted and loaded as a raw material substance, and formed into a columnar shape having a diameter of 10 cm and a height of 48 cm. A molded body obtained thus had a mass of 5.48 kg, a volume of 3,785 cm³, and a density of 1.45 g/cm³. In addition, a 75% hydrazine hydrate solution of hydrazine nitrate was subdivided by 2.49 kg and prepared as an explosive substance.

Subsequently, a detonation reaction was performed by using the explosive device as illustrated in FIG. 1 in the same manner as in the aforementioned Experimental Example 1. A container having a capacity of 200 L was used as the cooling container 30. In addition, 220 L of distilled water was used as the coolant 32. As a result, 2,059 g in total of carbon particles including 636 g of a 16 µm-sieve-passing material, 726 g of a 32 µm-sieve-passing material and 697 g of a 100 µm-sieve-passing material were obtained. The experiment contents, the recovery amount and yield of the carbon particles in this Experimental Example are shown in the following Table 2.

### «Experimental Example 5»

In this Experimental Example, carbon particles were produced in the same manner as in the aforementioned Experimental Example 3, except that the DNT as the raw material substance was changed from 3,750 cm³ to 3,800 cm³ in volume and from 1.46 g/cm³ to 1.44 g/cm³ in density; the use amount of the hydrazine-based liquid high explosive as the explosive substance was changed from 2.50 kg to 2.43 kg; and the amount (calculated value) of the residual oxygen gas in the chamber was changed from 191.0 g to 25.52 g. As a result, 1,465 g in total of carbon particles including 177 g of a 16 µm-sieve-passing material, 678 g of a 32 µm-sieve-passing material and 610 g of a 100 µm-sieve-passing material were obtained. The experiment contents, the recovery amount and yield of the carbon particles in this Experimental Example are shown in the following Table 2.

**Table 2**

| | | Experimental Example 1 | Experimental Example 2 | Experimental Example 3 | Experimental 4 | Experimental Example 5 |
|---|---|---|---|---|---|---|
| Raw material substance | Kind | DNT | DNT | DNT | 2,4-DNT | DNT |
| | Mass (kg) | 5.52 | 5.52 | 5.46 | 5.48 | 5.46 |
| | Volume (cm³) | 3770 | 3770 | 3750 | 3785 | 3800 |
| | Density (g/cm³) | 1.46 | 1.46 | 1.46 | 1.45 | 1.44 |
| Explosive substance | Kind | NH+HH¹⁾ | NH+HH¹⁾ | NH+HH¹⁾ | NH+HH¹⁾ | NH+HH¹⁾ |
| | Mass (kg) | 2.50 | 2.49 | 2.50 | 2.49 | 2.43 |
| Cooling container | Volume (L) | 100 | 200 | 200 | 200 | 200 |
| Coolant | Volume (L) | 120 | 220 | 220 | 220 | 220 |
| Explosion chamber | Internal volume (m³) | 30 | 30 | 30 | 30 | 30 |
| | Residual oxygen gas amount (g) | 279.9 | 279.9 | 191.0 | 279.9 | 25.52 |
| Carbon particles | 16µm-sieve-passing material (g) | 584 | 534 | 164 | 636 | 177 |
| | 32µm-sieve-passing material (g) | 907 | 1315 | 801 | 726 | 678 |
| | 100µm-sieve-passing material (g) | 557 | 485 | 680 | 697 | 610 |
| | Total recovery amount (g) | 2048 | 2334 | 1645 | 2059 | 1465 |
| | Yield (%)²⁾ | 37.1 | 42.3 | 30.1 | 37.6 | 26.8 |
| Diamond (D) | Content proportion (mass %) | 10.5 | 8.2 | 19.0 | 6.3 | 10.7 |
| Graphite carbon (G) | Content proportion (mass %) | 89.5 | 91.8 | 81.0 | 93.7 | 89.3 |
| Mass ratio | G/D | 8.52 | 11.20 | 4.26 | 14.87 | 8.35 |

| | | | | | | |
|---|---|---|---|---|---|---|
| ¹⁾ Hydrazine-based liquid high explosive obtained by mixing hydrazine nitrate (H₂N-NH₂·HNO₃) and hydrazine hydrate (H₂N-NH₂·H₂O) were mixed at a mass ratio of 3:1 ²⁾ Yield (%) = 100 × (total recovery amount (g) of carbon particles/[mass (kg) of raw material substance × 1000]) | | | | | | |

Next, the obtained carbon particles were observed by a transmission electron microscope (TEM) in the following procedure.

### <TEM Observation>

The obtained carbon particles were observed using a TEM having a CCD camera and a photographing magnification and capable of observing lattice images of diamond and graphite carbon having a lamination structure. Specific measurement conditions of the TEM are shown below.
Device name of TEM: transmission electron microscope, JEM-ARM200F, manufactured by JEOL Ltd.
Measurement method: suspension method, dispersion solvent: methanol
Accelerating voltage: 200 kV
CCD camera: UltraScan, manufactured by Gatan
Photographing magnification: 300,000 times and 800,000 times
Imaging magnification: 2,200,000 times, and 5,900,000 times when printed in A4 size

From the results of measurement using the TEM, it was observed that the carbon particles obtained by the production method of the present invention were formed of nano-scale diamond and graphite carbon. Detailed description will be made below.

Among the carbon particles obtained in Experimental Example 3, transmission electron microscopic (TEM) photographs of the 16 µm-sieve-passing material are shown in FIG. 3. FIG. 4 shows a drawing substitute photograph in which a part enclosed by c1 in a drawing substitute photograph c of FIG. 3 is enlarged.

Among the drawing substitute photographs shown in FIG. 3, in the photograph a shown in the upper left, a carbon particle having a round shape and found among the carbon particles was enlarged with an imaging magnification corresponding to 5,900,000 times. From the photograph a, it can be confirmed that the particle diameter of the carbon particle having the round shape is about 7.0 nm. Also in the photograph b shown in the upper right of FIG. 3, a carbon particle having a round shape and found among the carbon particles was enlarged with an imaging magnification corresponding to 5,900,000 times. From the photograph b, it can be confirmed that the particle diameter of the carbon particle having the round shape is about 17.5 nm. The result of the measured lattice spacing in the carbon particles having the round shapes shown in the photographs a and b in FIG. 3 was 2.11 Å. It is generally said that the D 111 plane lattice spacing in diamond is 2.06 Å, and the difference ratio therefrom is 2.4%. Therefore, the carbon particles having the round shapes can be regarded as diamond.

On the other hand, the imaging magnification of the photograph c shown in the lower left of FIG. 3 corresponds to 2,200,000 times. In the photograph c, carbon particles having round shapes and carbon particles having irregular lattice structures were observed. The particle diameters of the carbon particles having the round shapes and observed in the photograph c were about 2.0 to 4.0 nm. The imaging magnification of the photograph d shown in the lower right of FIG. 3 corresponds to 2,200,000 times. In the photograph d, carbon particles having round shapes and carbon particles having an irregular lattice structure were observed in the same manner as in the aforementioned photograph c. The particle diameters of the carbon particles having the round shapes and observed in the photograph d were about 6.0 to 10.0 nm.

FIG. 4 shows the photograph in which a part (part c1) of the photograph c shown in FIG. 3 is enlarged. As shown by the symbol G, a field where carbon particles having an irregular lattice structure can be observed is enlarged so that a lattice image thereof can be observed. The result of the observed plane interval of lamination was 3.46 Å. It is said that the 002 plane interval of lamination of hexagonal graphite (powder diffractometry) is 3.37 Å, and the difference ratio therefrom is 2.4% in the same manner. Thus, the observed plane interval of the lamination substantially agreed with the plane interval of lamination of graphite. It is therefore considered that the laminated nano-scale carbon particles shown by the symbol G are of graphite carbon (nanographite), occupying a main proportion of the carbon particles. Further, in the photograph shown in FIG. 4, the dimension in a direction perpendicular to a lamination direction was 1.5 to 10 nm. As is apparent from FIG. 4, it is found that the lamination direction of each graphite piece is irregular, and the lamination directions of adjacent ones of the graphite pieces are not identical to each other.

Next, X-ray diffraction (XRD) of the obtained carbon particles was measured and evaluated.

### <XRD Quantitative Method>

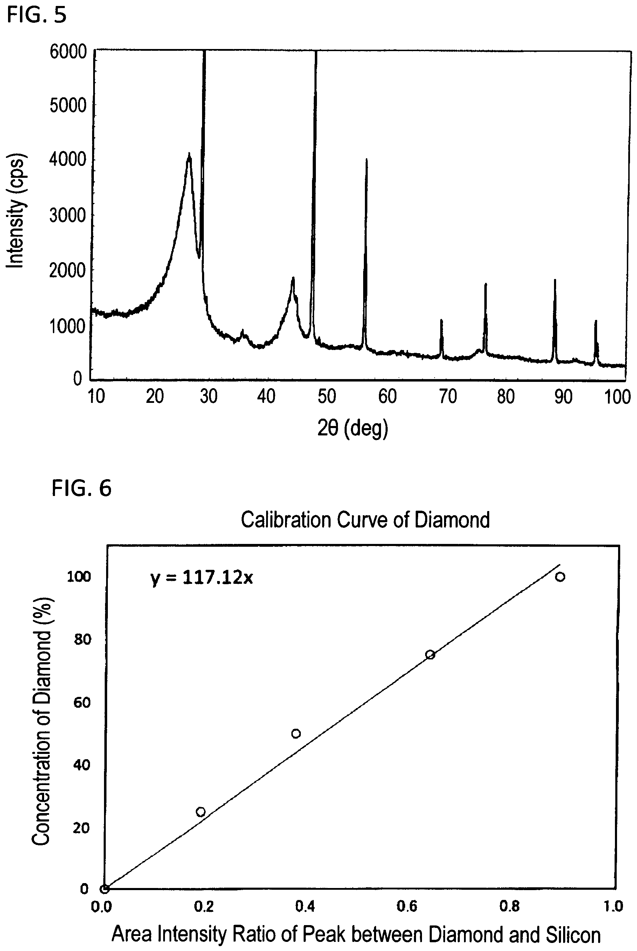

First, among the carbon particles obtained in Experimental Example 3, the X-ray diffraction chart of the 100 µm-sieve-passing material is shown in FIG. 5.

Measuring conditions of the X-ray diffraction are shown below.
Device name of X-ray diffraction device: Horizontal X-ray diffraction device, SmartLab, manufactured by Rigaku Corporation
Measurement method: θ-2θ
X-ray source: Cu-Kα ray
Excitation voltage-current: 45 kV-200 mA
Divergence slit: 2/3°
Scattering slit: 2/3°
Receiving slit: 0.6 mm

Next, among the carbon particles obtained in Experimental Examples 1 to 5, XRD of the carbon particles in the 16 µm-sieve-passing material was measured. From the measurement result, integrated intensity was obtained about a diffraction peak appearing near 20=75° in the D20 surface of diamond, and the proportion of diamond contained in the carbon particles was obtained using each calibration curve prepared in advance.

As a standard substance for determining the quantity of diamond, diamond which had been purified by removing graphite carbon and the like with perchloric acid from diamond-containing carbon particles separately produced in the present invention was used. A silicon powder (Stansil-G03A manufactured by Osaka Yakken Co. Ltd., D50=5.2 µm) of 10% by mass to the total carbon amount was added as an internal standard.

The calibration curve for diamond was prepared using 5 standard samples by performing 4-point measurement from the ratio of the integrated intensity of the aforementioned diffraction peak and the integrated intensity of the diffraction peak on each of the Si 220 plane and the Si 311 plane of a silicon crystal added to each of the samples. The two peaks of the silicon crystal is used to suppress the influence of orientation of the powdered silicon.

The 5 standard samples were prepared by mixing silicon crystals with the diamond so as to provide 0% by mass, 25% by mass, 50% by mass, 75% by mass and 100% by mass, as content proportions of diamond, respectively.

The calibration curve for diamond was obtained by plotting with the concentration of diamond on the ordinate and with the peak area intensity ratio D220/(Si220+Si311) of diamond and silicon on the abscissa. A relational expression between the concentration Y of diamond and the intensity ratio X was Y = 117.12 × X, in accordance with linear approximation by a least squares method. The obtained calibration curve is shown in FIG. 6.

The obtained diamond content proportion was divided by the estimated graphite content proportion to calculate the mass ratio G/D. It was found that diamond and graphite carbon were main components. Carbons having other structures could not be observed.

The content proportion of diamond (D: when the carbon particles were regarded as 100% by mass) was obtained in the carbon particles obtained in each of Experimental Examples 1 to 5. Of the carbon particles, carbon particles other than diamond were assumed as graphite carbon, and the content proportion (G) of graphite carbon was calculated. The mass ratio G/D was calculated based on the content proportion (D) of diamond contained in the carbon particles and the content proportion (G) of graphite carbon contained in the carbon particles. The result is also shown in the aforementioned Table 2.

From Table 2, it is found that graphite carbon can be produced by the detonation method even when DNT which is an inexpensive non-explosive raw material is used as the raw material substance and even when liquid high explosive is used as the explosive substance.

For the carbon particles obtained in each of the aforementioned Experimental Examples 1 to 5, the value of G/(G+D) was calculated based on the content proportion (D) of diamond contained in the carbon particles and the content proportion (G) of graphite carbon contained in the carbon particles. The calculation result is shown in the following Table 3 together with the aforementioned mass ratio G/D. In addition, the following Table 3 shows the values of G/D and G/(G+D) in a commercial product available as nanodiamond on the market.

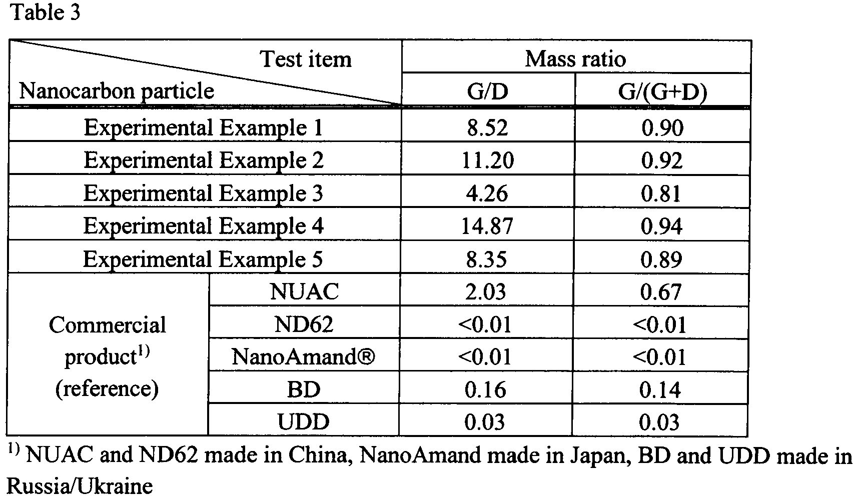

From the aforementioned Table 3, it is found that the content proportion of graphite carbon in the carbon particles obtained in the aforementioned Experimental Examples 1 to 5 is higher than those in the commercial products.

Next, a crystallite size was obtained from the X-ray diffraction data using the Scherrer equation: D=Kλ/βcosθ. Here, D designates the crystallite size (Å), λ designates a wavelength of an X-ray tube bulb (1.5418 Å of Cu-Kα ray in the examples), β designates a spread of diffracted X-rays caused by the crystallite, θ designates an angle of diffraction (rad), and K designates a Scherrer constant, which was set at 0.9 (B.D. Cullity (Author), Gentaro Matsumura (translator), "X-ray diffraction main theory (new edition)", Agne Shofusha; March, 1999). The spread β was obtained from β = (βexp²-βi²)^{1/2} using a width βexp of the measured diffracted X-rays and a spread βi of the diffracted X-rays caused by the device.

The measured diffracted X-rays were subjected to smoothing, background removal and Kα2 removal. After that, half-value widths of a peak near 26° (generally referred to as G002) and a peak near 43° (generally referred to as D111) were obtained, and each of the obtained half-value widths was set as the width βexp of the measured diffracted X-rays. The G002 peak is a peak caused by graphite carbon, and the D111 peak is a peak caused by diamond. In addition, 10% by mass of Si powder (Stansil-G03A manufactured by Osaka Yakken Co. Ltd., 5.2 µm in center particle size) was added, and a half value width of a peak near 47 °(generally referred to as Si220) in diffraction X-rays was set as βi.

SmartLab which is a horizontal X-ray diffraction device manufactured by Rigaku Corporation was used as an X-ray diffraction device. It is the same device as in the aforementioned <XRD Quantitative Method>.

Crystallite sizes estimated from the measured X-ray diffraction data of the carbon particles obtained in the aforementioned Experimental Examples 1 to 5 are shown in the following Table 4. As a result, it is considered that the crystallite size of diamond calculated based on the half value width of the D111 peak is 2 to 5 nm. That is, the crystallite size of diamond obtained from the diffracted X-ray width of diamond by the Scherrer equation substantially agrees with the result of TEM observation which will be described later.

On the other hand, the crystallite size of graphite carbon calculated based on the half value width of the G002 peak was 2 to 4 nm. In this manner, the crystallite size is estimated on the assumption that the plane interval is fixed and only the crystallite size is different. However, it has been found that graphite carbon has a so-called turbostratic structure in which hexagonal net surfaces of graphite are layered in parallel but regularity cannot be observed in its orientation. It is therefore assumed that the crystallite size obtained from a mixture of peaks near 26° in which various deformed substances take part is not correct. Thus, the crystallite size of graphite carbon estimated in this manner is regarded as reference data.

**Table 4**

| | Diffracted X-ray width Bexp | | | Diffracted X-ray spread | | Estimated crystallite size (Å) |
|---|---|---|---|---|---|---|
| | Part | 2θ (°) | Half value width (rad) | Device βi | Spread β caused by crystallite (rad) | |
| | | | | Si220 half value width (rad) | | |
| Experimental | G 002 | 25.7 | 0.078 | 0.003 | 0.0784 | 21 |
| Example 1 | D 111 | 43.6 | 0.063 | | 0.0632 | 24 |
| Experimental Example 2 | G 002 | 25.8 | 0.070 | 0.003 | 0.0702 | 25 |
| | D 111 | 43.6 | 0.056 | | 0.0564 | 26 |
| Experimental Example 3 | G 002 | 26.0 | 0.054 | 0.003 | 0.0538 | 39 |
| | D 111 | 43.8 | 0.026 | | 0.0262 | 54 |
| Experimental Example 4 | G 002 | 25.9 | 0.079 | 0.003 | 0.0789 | 24 |
| | D 111 | 43.6 | 0.056 | | 0.0556 | 27 |
| Experimental Example 5 | G 002 | 26.0 | 0.052 | 0.003 | 0.0520 | 42 |
| | D 111 | 43.0 | 0.052 | | 0.0520 | 28 |

Next, the particle size of primary particles of diamond, the lattice spacing in the D111 plane of diamond, and the plane interval in the lamination of graphite carbon were measured based on photographs taken by TEM observation. The results are shown in the following Table 5. The crystallite size of diamond calculated based on the half value width of the D111 peak shown in the aforementioned Table 4 is also shown in the following Table 5. As is apparent from the following Table 5, the particle size of the primary particles observed in the transmission electron microscopic (TEM) photographs of the carbon particles were about several to 20 nm. However, it is assumed that a particle with the smallest particle size of the particles shown in the photographs was expressed in the crystallite size estimated from the X-ray diffraction data.

**Table 5**

| | Experimental result | | | |
|---|---|---|---|---|
| | XRD crystallite size (Å)¹⁾ | TEM observed size (Å)²⁾ | | |
| | | Diamond particle size | Diamond Dill | Graphite carbon |
| Experimental Example 1 | 24 | - | - | - |
| Experimental Example 2 | 26 | - | - | - |
| Experimental Example 3 | 54 | Several to several tens | 2.1 | 3.5 |
| Experimental Example 4 | 27 | Several to several tens | - | 3.8 |
| Experimental Example 5 | 28 | - | - | - |

| | | | | |
|---|---|---|---|---|
| ¹⁾ XRD crystallite size: diamond crystallite size (Å) obtained from line width of X-ray diffraction line ²⁾ TEM observed size (Å): primary particle size of diamond, lattice spacing of the diamond D111 plane, and plane interval (Å) in the lamination of graphite carbon, obtained approximately from transmission electron microscopic photographs | | | | |

Next, the carbon particles obtained in Experimental Example 4 were fluorinated, and fluorine was quantified by combustion and ion chromatography. As a result, the content proportion of fluorine was 53% by mass.

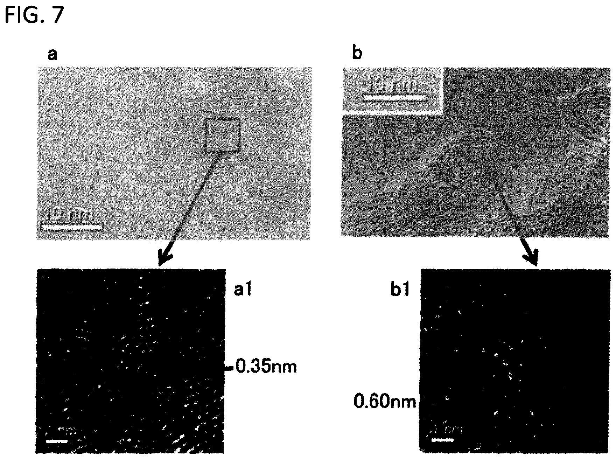

FIG. 7 shows drawing substitute photographs in which particles obtained by fluorination of the carbon particles obtained in Experimental Example 4 were observed by a transmission electron microscope (TEM). A device and measuring conditions used for the TEM observation were the same as described above. In FIG. 7, the drawing substitute photograph a shows the carbon particles which have not been fluorinated yet, and the drawing substitute photograph a1 is an enlarged view of a part enclosed by a rectangle in the drawing substitute photograph a. In FIG. 7, the drawing substitute photograph b shows the carbon particles which have been fluorinated, and the drawing substitute photograph b1 is an enlarged view of a part enclosed by a rectangle in the drawing substitute photograph b.

From the drawing substitute photographs a1 and b1 shown in FIG. 7, it is found that the interval of lamination is expanded from 0.35 nm to 0.60 nm with addition of 53% by mass of fluorine.

Furthermore, a composition and a bonding state of a surface of each fluorinated carbon particle was examined by X-ray photoelectron spectroscope (XPS). The outermost surface of the fluorinated carbon particle was analyzed qualitatively by measurement of broad-band photoelectron spectra. After that, narrow-band photoelectron spectra were measured for elements detected in the qualitative analysis. An elemental composition ratio (atom %) was calculated from a narrow range photoelectron peak area intensity ratio and a relative sensitivity coefficient, and a binding state was estimated from a peak position.

### <XPS Measurement Conditions>

Analyzer: "Quantera SXM (fully automatic scanning X-ray photoelectron spectroscope)" manufactured by Physical Electronics Co., Ltd.
X-ray source: monochromatic Al Kα
X-ray output: 25.1 W
X-ray beam size: 100 µm ϕ
Photoelectron extraction angle: 45°

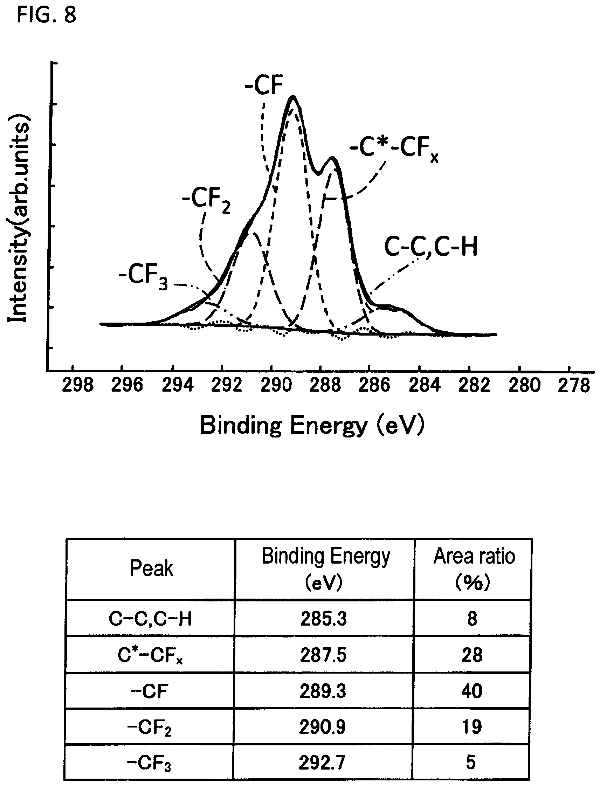

FIG. 8 shows a result in which, of a broad-band photoelectron spectrum and a narrow-band photoelectron spectrum measured from the outermost surface of the fluorinated carbon particles obtained in Experimental Example 4, a C1s narrow-band photoelectron spectrum was subjected to separation of peaks. The table shown in FIG. 8 shows binding energy and an area ratio of each peak calculated from the C1s narrow-band photoelectron spectrum. It is found that added fluorine is supported on the carbon particle by a C-F bond, a C-F₂ bond, a C-F₃ bond and a C*-Fx bond. The C-F bond was most frequently recognized in fluorinated carbon particles obtained in Experimental Example 4, and the C-F₂ bond and the C-F₃ bond were second and third most frequently recognized.

Next, the surfaces of base material particles were coated with the carbon particles obtained in the aforementioned Experimental Example 3, 4 or 5. As the base material particles, (a) urethane resin particles, (b) acrylic resin particles, (c) nylon resin particles, (d) high molecular weight polyethylene resin particles, (e) SiC particles, (f) inactive alumina particles , (g) SUS316L stainless steel particles, (h) copper particles, (i) bronze particles, and (j) maraging steel particles were used. Specific description will be made below.
(a) "C-300" (average particle size ϕ22 µm, specific gravity 1.16 g/cm³) manufactured by Negami Chemical Industrial Co., Ltd., or "JB-300T" (average particle size ϕ22 µm, specific gravity 1.16 g/cm³) manufactured by Negami Chemical Industrial Co., Ltd. was used as the aforementioned urethane resin particles.
(b) "SE-20T" (average particle size ϕ22 µm, specific gravity 1.21 g/cm³) manufactured by Negami Chemical Industrial Co., Ltd., "GR-300T" (average particle size ϕ22 µm, specific gravity 1.21 g/cm³) manufactured by Negami Chemical Industrial Co., Ltd., "TAFTIC AR650M" (average particle size ϕ30 µm, specific gravity 1.35 g/cm³) manufactured by Toyobo Co., Ltd., "TAFTIC FH-S010" (average particle size ϕ 10 µm, specific gravity 1.17 g/cm³) manufactured by Toyobo Co., Ltd., or "J-4PY" (average particle size ϕ2.2 µm, specific gravity 1.21 g/cm³) manufactured by Negami Chemical Industrial Co., Ltd. was used as the aforementioned acrylic resin particles.
(c) "TR-2" (average particle size ϕ20 µm, specific gravity 1.13 g/cm³) manufactured by Toray Industries, Inc. was used as the aforementioned nylon resin particles.
(d) "MIPELON XM-221U" (average particle size ϕ30 µm, specific gravity 0.94 g/cm³) manufactured by Mitsui Chemicals Co. Ltd. was used as the aforementioned high molecular weight polyethylene resin particles.
(e) "SSC-A15" (average particle size ϕ18.6 µm, specific gravity 1.91 g/cm³) manufactured by Shinano Electric Refining Co., Ltd. was used as the aforementioned SiC particles.
(f) "V-250" (average particle size unknown) manufactured by Union Showa K.K. or "VERSAL-G" (average particle size ϕ50 µm, specific gravity 1.93 g/cm³) manufactured by Union Showa K.K. was used as the aforementioned inactive alumina particles.
(g) SUS316L stainless steel particles manufactured by SANYO SPECIAL STEEL Co., Ltd. was used as the aforementioned SUS316L stainless steel particles. The average particle size was ϕ20 µm, and the specific gravity was 7.98 g/cm³.
(h) Pure copper particles manufactured by HIGH PURITY CHEMICALS Co., Ltd. was used as the aforementioned copper particles. The average particle size was ϕ20 µm, and the specific gravity was 8.82 g/cm³.
(i) Bronze particles manufactured by Sandvik AB was used as the aforementioned bronze particles. It had a composition of Cu-15%Sn-0.4%P. The average particle size was ϕ27.4 µm, and the specific gravity was 5.2 g/cm³.
(j) Maraging steel particles manufactured by Sandvik AB was used as the aforementioned maraging steel particles. It was 18Ni300 steel. The average particle size was ϕ32.4 µm, and the specific gravity was 8.0 g/cm³.

The carbon particles obtained in Experimental Example 3, 4 or 5, and the aforementioned base material particles were put in a "MP5 type compositor" manufactured by NIPPON COKE & ENGINEERING Co., Ltd., and mechanically combined with a blade rotation speed of 10,000 rpm and for a stirring time of 10 to 30 minutes to produce coated particles. The MP5 type compositor had a tank capacity of 6.5 L, a processing capacity of about 3 L, and a motor of 2.2 kW. The carbon particles and the base material particles were combined at the following specific combination ratios.
(a-1) Urethane resin particles "C-300" were set at 500 g, and the carbon particles obtained in Experimental Example 5 were set at 2% by mass. Film thickness (estimated film thickness) estimated from the sizes and specific gravities of the base material particles and the carbon particles was 42 nm on these conditions. The aforementioned amount of the carbon particles is a value when the amount of the base material particles is regarded as 100% by mass (the same thing can be applied to the following paragraphs). That is, in (a-1), 500 g of the urethane resin particles were coated with 100 g of the aforementioned carbon particles.
(a-2) Urethane resin particles "JB-300T" were set at 500 g, and the carbon particles obtained in Experimental Example 5 were set at 2% by mass. Estimated film thickness was 42 nm.
(b-1) Acrylic resin particles "SE-20T" were set at 500 g, and the carbon particles obtained in Experimental Example 5 were set at 2% by mass. Estimated film thickness was 44 nm.
(b-2) Acrylic resin particles "GR-300" were set at 500 g, and the carbon particles obtained in Experimental Example 5 were set at 2% by mass. Estimated film thickness was 44 nm.
(b-3) Acrylic resin particles "TAFTIC AR650M" were set at 500 g, and the carbon particles obtained in Experimental Example 5 were set at 2% by mass. Estimated film thickness was 67 nm.
(b-4) Acrylic resin particles "TAFTIC FH-S010" were set at 300 g, and the carbon particles obtained in Experimental Example 3 were set at 2% by mass. Estimated film thickness was 19 nm.
(b-5) Acrylic resin particles "J-4PY" were set at 230 g, and the carbon particles obtained in Experimental Example 3 were set at 5% by mass. Estimated film thickness was 4.4 nm.
(c) Nylon resin particles "TR-2" were set at 600 g, and the carbon particles obtained in Experimental Example 5 were set at 5% by mass. Estimated film thickness was 93 nm.
(d) High molecular weight polyethylene resin particles "MIPELON XM-221U" were set at 250 g, and the carbon particles obtained in Experimental Example 3 were set at 2% by mass. Estimated film thickness was 47 nm.
(e) SiC particles "SSC-A15" were set at 500 g, and the carbon particles obtained in Experimental Example 5 were set at 5% by mass. Estimated film thickness was 146 nm.
(f-1) Inactive alumina particles "V-250" were set at 500 g, and the carbon particles obtained in Experimental Example 5 were set at 5% by mass. The average particle size is not known accurately because the particle size distribution of "V-250" is not presented. On the assumption that the average particle size (d50) is 5 µm, estimated film thickness is 396 nm.
(f-2) Inactive alumina particles "VERSAL-G" were set at 500 g, and the carbon particles obtained in Experimental Example 5 were set at 5% by mass. Estimated film thickness was 396 nm.
(g) SUS316L stainless steel particles were set at 1,000 g, and the carbon particles obtained in Experimental Example 3 were set at 2% by mass. Estimated film thickness was 259 nm.
(h) Pure copper particles were set at 1,000 g, and the carbon particles obtained in Experimental Example 4 were set at 2% by mass. Estimated film thickness was 286 nm.
(i) Bronze particles were set at 500 g, and the carbon particles obtained in Experimental Example 3 were set at 2% by mass. Estimated film thickness was 233 nm.
(j) Maraging steel particles were set at 1000 g, and the carbon particles obtained in Experimental Example 4 were set at 2% by mass. Estimated film thickness was 421 nm.

Next, the obtained coated particles were observed by a field emission-type scanning electron microscope (FE-SEM), and it was checked whether the surfaces of the base material particles were coated with the carbon particles or not. "JSM-7000F" manufactured by JEOL Ltd. was used as the FE-SEM, with an accelerating voltage of 7.5kV, an imaging method of secondary electron imaging, and an observation magnification of 200 to 3,000 times.

Further, a part of a surface layer of a coated particle was cut out by a focused ion beam (FIB) apparatus, and observed. "IM-4000 (ion milling system)" manufactured by Hitachi High-Technologies Corporation was used as a section processing apparatus, using an ion source of argon, an accelerating voltage of 4.0kV, and a processing temperature of -10°C. A section was observed by "S-5500 (field emission-type scanning electron microscope; FE-SEM)" manufactured by Hitachi High-Technologies Corporation, using an accelerating voltage of 2.0kV, an imaging method of secondary electron imaging, a reflected electron image (LA-BSE), and an observation magnification of 200 to 25,000 times.

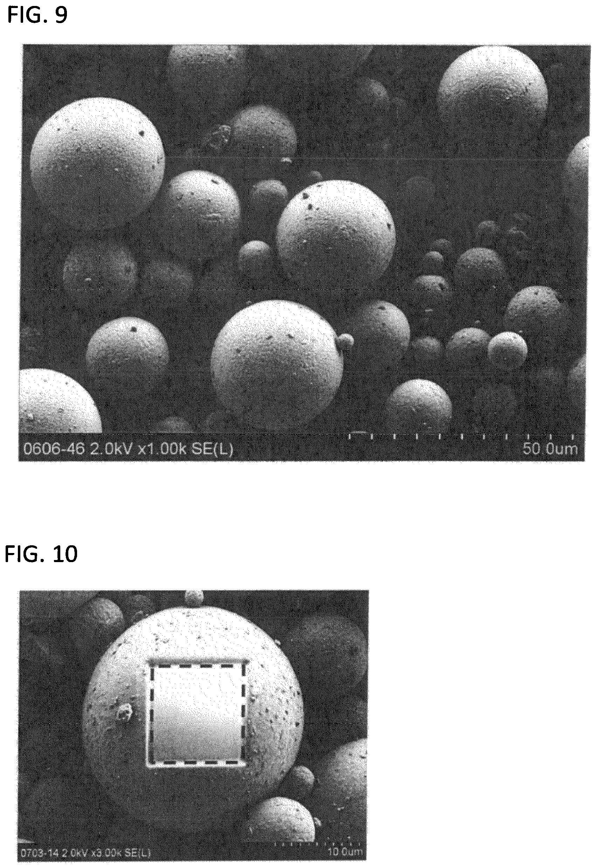

FIG. 9 shows the drawing substitute photograph in which, among the obtained coated particles, the surfaces of the coated particles obtained in the aforementioned paragraph (a-1) were observed and taken by the FE-SEM.

FIG. 10 shows the drawing substitute photograph in which a part of a surface layer of a coated particle obtained in the aforementioned paragraph (a-1) was cut out by the FIB apparatus and taken so that the coated carbon particle could be compared with an internal urethane resin particle.

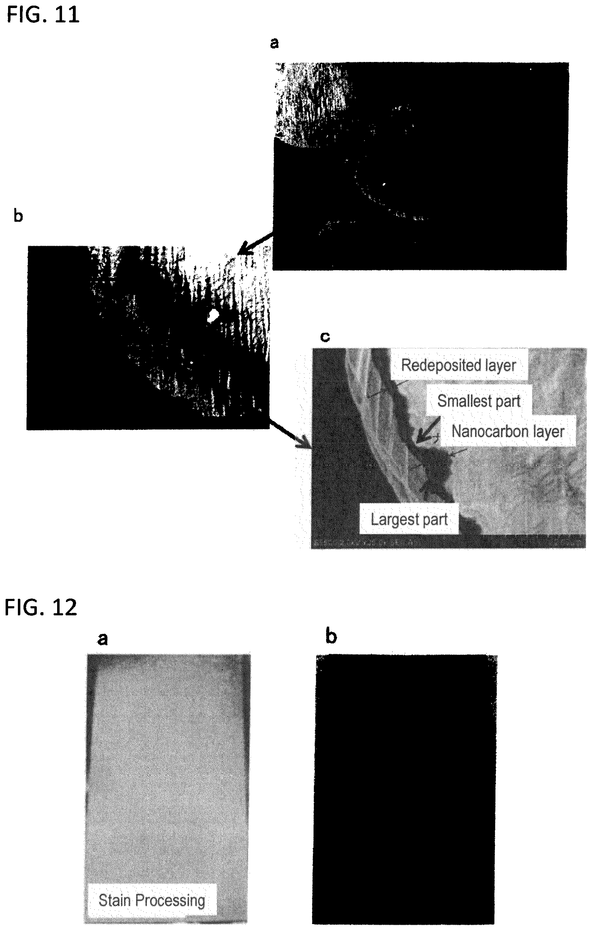

Further, in the drawing substitute photograph a shown in FIG. 11, a coated particle obtained in the aforementioned paragraph (a-1) was frozen in a cryo CP apparatus and then cut with an ion beam, and a section of the coated particle was observed and taken by the FE-SEM. The drawing substitute photograph b shown in FIG. 11 is a photograph in which a part enclosed by a rectangle in the drawing substitute photograph a shown in FIG. 11 is enlarged. The drawing substitute photograph c shown in FIG. 11 is a photograph in which a part enclosed by a rectangle in the drawing substitute photograph b shown in FIG. 11 is enlarged.

As is apparent from FIG. 9, FIG. 10 and FIG. 11, it is found that the surfaces of the base material particles are coated with the carbon particles. In addition, as is apparent from FIG. 11, the film thickness of the observed coated particle was about 30 nm in the smallest part and about 400 nm in the largest part. The film thickness was observed as 40 to 60 nm on average. It is found that the observed average film thickness substantially agrees with the estimated film thickness of 42 nm. In FIG. 11, the redeposited layer means that waste generated during cutting with an ion beam to obtain a section is deposited again on a surface of a sample.

Next, the coated particles obtained by coating the surfaces of the base material particles with the carbon particles obtained in the aforementioned Experimental Example 5 or 3 were supported on the surface of a substrate material by plasma spraying, thereby producing a functional material. More specifically, the coated particles obtained in the aforementioned paragraphs (e), (g) and (i) were used as the aforementioned coated particles. That is, in the coated particles (e), the SiC particles "SSC-A15" were coated with the carbon particles obtained in Experimental Example 5. In the coated particles (g), the SUS316L stainless steel particles were coated with the carbon particles obtained in Experimental Example 3. In the coated particles (i), the bronze particles were coated with the carbon particles obtained in Experimental Example 3. Then, the coated particles were supported on the surface of the substrate material by plasma spraying.

A SUS304 stainless steel sheet, a carbon steel sheet, a bronze sheet and an aluminum sheet were used as the substrate materials. The plasma spraying was performed using a F4 type plasma spraying apparatus manufactured by Sulzer Metco Japan Ltd. The measurement conditions of the plasma spraying are shown in the following Table 6.

**Table 6**

| | | (e) | (g) | (i) |
|---|---|---|---|---|
| Base material particle | | SiC particle | SUS316L particle | Bronze particle |
| Carbon particle | | Experimental Example 5 | Experimental Example 3 | Experimental Example 3 |
| Carbon particle proportion | | 2% bv mass | 2% by mass | 5% by mass |
| Kind of substrate material | | metal | metal | metal |
| Argon | Pressure | 75 psi (5.25 kg/cm³) | 75 psi (5.25 kg/cm³) | 75 psi (5.25 kg/cm³) |
| | Flow rate | 38.0 SLPM | 55.0 SLPM | 55.0 SLPM |
| Hydrogen | Pressure | 50 psi (3.50 kg/cm³) | 50 psi (3.50 kg/cm³) | 50 psi (3.50 kg/cm³) |
| | Flow rate | 12.0 SLPM | 9.5 SLPM | 9.5 SLPM |
| Current | | 600 A | 600 A | 600 A |
| Voltage | | 72 V | 72 V | 72 V |
| Thermal-spraying distance | | 120 mm | 100 mm | 140 mm |
| Traverse velocity | | 750 m/s | 750 m/s | 750 m/s |
| Step | | 3 mm | 3 mm | 3 mm |
| Power feed rate | | 20 g/min | 20 g/min | 20 g/min |
| Number of paths | | 5 | 5 | 5 |
| Preheating of base material | | No | No | Yes |

| | | | | |
|---|---|---|---|---|
| SLPM: standard liter/min | | | | |

When the mass of the obtained sample of the metal substrate material was measured after thermal spraying, increase in mass was detected. Thus, it was found that the coated particles were supported on the surface of the substrate material by the plasma spraying.

FIG. 12 shows the drawing substitute photographs in which the SUS304 stainless steel sheet used as the substrate material and the obtained functional material were taken. Coated particles obtained by mechanical combination of 2% by mass of the carbon particles in Experimental Example 3 with the base material particles of SUS316 stainless steel powder was used as a material to be thermal-sprayed. In the drawing substitute photograph a of FIG. 12, the substrate material against which the coated particles had not been plasma-sprayed yet was taken. In the drawing substitute photograph b of FIG. 12, the functional material in which the coated particles obtained in the aforementioned paragraph (g) had been plasma-sprayed against the substrate material was taken. When the film thickness of the functional material was estimated from the increase in mass, it was assumed that a thermal-sprayed coating of about 34 µm on average was formed by the coated particles.

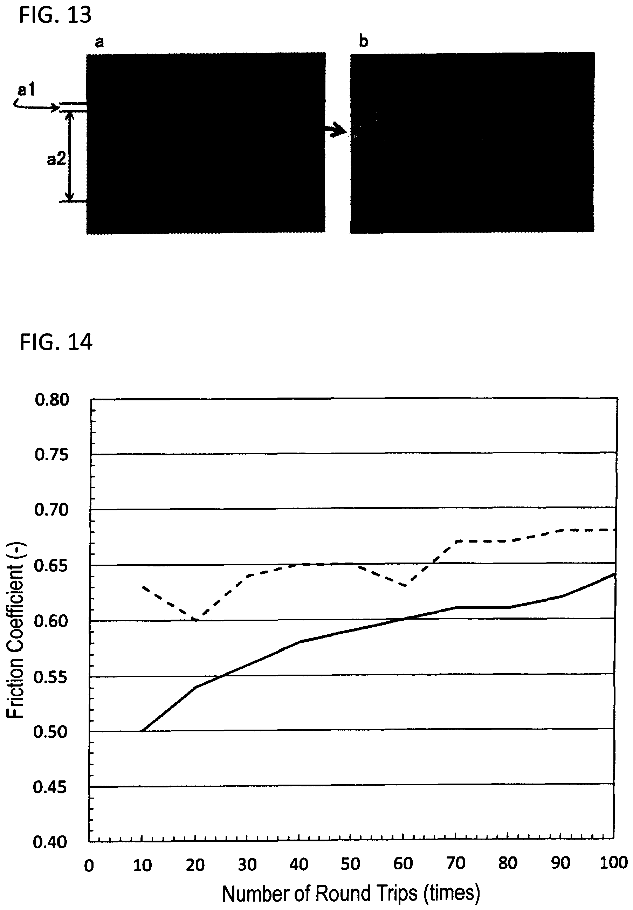

In the drawing substitute photograph a shown in FIG. 13, the functional material shown in the photograph b of FIG. 12 was cut by a fine cutter, and a section thereof was observed and taken by the FE-SEM. In the view b of FIG. 13, a part enclosed by a dotted rectangle in the drawing substitute photograph a shown in FIG. 13 is enlarged. In the drawing substitute photograph a shown in FIG. 13, a1 designates a thermal-sprayed coating formed by the coated particles, and a2 designates a SUS304 stainless steel sheet as the substrate material.

As is apparent from FIG. 12 and FIG. 13, it is found that coated particles can be supported on a substrate material by plasma spraying. In addition, the observed film thickness of the thermal-sprayed coating formed by the coated particle was about 20 µm in the smallest part and about 60 µm in the largest part. The film thickness was observed as 40 to 50 µm on average. It is found that the observed average film thickness substantially agrees with the estimated film thickness of 34 µm.

Thickness (µm) of the thermal-sprayed coating in the functional material produced in such a manner that the coated particles (g) or (i) obtained by coating the surfaces of the base material particles with the carbon particles obtained in the aforementioned Experimental Example 3 were supported on the surface of the substrate material by plasma spraying was calculated from a change in mass. The calculation results are shown in the following Table 7.

In addition, Vickers hardness of the thermal-sprayed coating in the functional material produced in such a manner that the coated particles (g) or (i) obtained by coating the surfaces of the base material particles with the carbon particles obtained in the aforementioned Experimental Example 3 were supported on the surface of the substrate material by plasma spraying was measured. More specifically, the coating particles (g) of SUS316L stainless steel particles coated with the carbon particles obtained in the aforementioned Experimental Example 3 or the coating particles (i) of bronze particles coated with the carbon particles obtained in the aforementioned Experimental Example 3 are supported on the surface of each substrate material (a SUS304 stainless steel sheet, a carbon steel sheet, a bronze sheet, or an aluminum sheet) by plasma spraying on the conditions shown in the aforementioned Table 6, thereby producing the functional material.

The hardness was measured on the following conditions. Average values of measurement results are shown in the following Table 7.

### <Hardness Measuring Conditions>

Measuring device: "micro hardness tester HM-220" manufactured by Mitutoyo Corporation
Applied load: 0.1 kgf or 0.05 kgf
Load time: 10 seconds
Measurement position: 5 points in desired positions of thermal-sprayed coating

The following Table 7 shows Vickers hardness (Hv) of each substrate material (a SUS304 type stainless steel sheet, a carbon steel sheet, a bronze sheet and an aluminum sheet) as reference data.

In addition, a sample in which SUS316L stainless steel particles manufactured by SANYO SPECIAL STEEL Co., Ltd. were supported on the surface of each substrate material was produced by plasma spraying on the conditions (g) shown in the aforementioned Table 6, and the Vickers hardness of the thermal-sprayed coating was measured as reference data in the following Table 7. The measurement results are shown together in the following Table 7.

From the following Table 7, the following consideration can be made. It is found that when the coated particles in the present invention are supported on the surface of the substrate material, the Vickers hardness of the surface can be improved to be higher than that of the substrate material itself. Further, it is found that when the coated particles in the present invention are supported on the surface of the substrate material, the Vickers hardness of the surface can be improved to be higher than that when SUS316L stainless steel particles are supported on the surface of the substrate material. That is, it is found that when the coated particles in which the surfaces of SUS316L stainless steel particles are coated with the carbon particles are used, the Vickers hardness can be improved by about 5 to 10%.

**Table 7**

| | | | | (g) | (i) | (Reference) |
|---|---|---|---|---|---|---|
| Base material particle | | | | SUS316L particle | Bronze particle | SUS316L particle |
| Carbon particle | | | | Experimental Example 3 | Experimental Example 3 | - |
| | SUS304 stainless steel sheet | | | 34 | 18 | 40 |
| | Carbon steel sheet | Thickness of thermal-sprayed coating | | 29 | 16 | 36 |
| | Bronze sheet | calculated from change in mass (µm) | | 38 | 28 | 35 |
| | Aluminum sheet | | | 55 | 40 | 41 |
| | SUS304 stainless steel sheet | | | 380.6 | 194.5 | 340.8 |
| Substrate | Carbon steel sheet | Hardness of thermal-sprayed coating (Hv) | | 359.8 | 195.3 | 311.2 |
| material | Bronze sheet | | | 372.1 | 197.0 | 339.1 |
| | Aluminum sheet | | | 407.3 | 217.8 | 353.0 |
| | SUS304 stainless steel sheet | | 140 to 200 | - | - | - - |
| | Carbon steel sheet | Hardness of substrate | 150 | - | - | - - |
| | Bronze sheet | material (Hv) | 50 | - | - | - |
| | Aluminum sheet | | 25 | - | - | - |
| Applied load in Vickers hardness measurement (kgf) | | | | 0.1 | 0.05 | 0.1 |

Next, the coated particles obtained by coating the surfaces of the base material particles with the carbon particles obtained in the aforementioned Experimental Example 3 were supported on the surface of the substrate material by plating, thereby producing a functional material. Alumina powder having a diameter ϕ of 4.2 µm was used as the base material particles.

An aluminum alloy (A5052) sheet was used as the substrate material. The dimensions of the sheet were 80mm × 50mm × 0.8mm in thickness.

The carbon particles obtained in Experimental Example 3, and the aforementioned base material particles were put in a "MP5 type compositor" manufactured by NIPPON COKE & ENGINEERING Co., Ltd., and mechanically combined with a blade rotation speed of 10,000 rpm and for a stirring time of 20 minutes to produce coated particles. The MP5 type compositor had a tank capacity of 6.5 L, a processing capacity of about 3 L, and a motor of 2.2 kW. The carbon particles and the base material particles were combined at the following specific combination ratios.
(f-3) Spherical alumina "DAW-03" manufactured by Denka Company Limited was set at 200 g as inactive alumina particles, and the carbon particles obtained in Experimental Example 3 were set at 5.0% by mass. Estimated film thickness was 0.024 µm.

Next, the aforementioned coated particles were supported on the surface of the substrate material by plating. Electroless (chemical) plating was used as the plating. A plating bath in which the aforementioned coated particles were dispersed in an Ni-P bath so that the concentration of the coated particles could reach 1.0 g/L was used. The plating bath temperature was set at 80°C, and the plating time was set at 60 minutes. A plating solution was stirred during the plating. After the plating, a heat treatment for retention at 100°C for 30 minutes was performed. The coating ratio of the surface of the substrate material with a plated layer was 100%. When the mass of the obtained sample after the plating was measured, increase in mass could be detected. It was found that the coated particles were supported on the surface of the substrate material by the plating.

As a comparative sample, a plated layer was formed on the surface of the substrate material on the same conditions except that an Ni-P bath where the aforementioned coated particles were not dispersed was used. The coating ratio of the surface of the substrate material with the plated layer was 100%.

The film thickness of the plated layer in each sample after plating was calculated from a change in mass. As a result, the film thickness of the plated layer formed in combination with the coated particles was 38 µm, and the film thickness of the plated layer formed without combination with the coated particles was 25 µm.

In addition, the Vickers hardness of each plated layer was measured on the following conditions. As a result, the hardness of the plated layer formed in combination with the coated particles was 586 Hv, and the hardness of the plated layer formed without combination with the coated particles was 681 Hv.

### <Hardness Measuring Conditions>

Measuring device: "micro hardness tester HM-102" manufactured by Mitutoyo Corporation
Applied load: 0.025 kgf
Load time: 10 seconds
Measurement position: 5 points in desired positions of plated layer

Further, the surface roughness of the plated layer was measured in accordance with JIS B0601 (2013). For the surface roughness, arithmetic average roughness (Ra) and maximum sectional height (Rt) of a roughness curve were measured with a reference length of 3 mm in measurement. As a result, in the plated layer formed in combination with the coated particles, the arithmetic average roughness (Ra) was 16.00 µm, and the maximum sectional height (Rt) of the roughness curve was 16.50 µm. On the other hand, in the plated layer formed without combination with the coated particles, the arithmetic average roughness (Ra) was 0.28 µm, and the maximum sectional height (Rt) of the roughness curve was 2.20 µm.

As is apparent from the aforementioned results, it can be considered that particularly in application to electroless plating, effects such as improvement of productivity due to increase in deposition rate, reduction in mist or environmental load within a factory due to decrease in bath temperature, reduction in electric power cost, simplification of operation, etc. can be obtained by the combination of the coated particles, in addition to advantages of lubricity and wear resistance.

The diameter ϕ of the inactive alumina particles used as the base material particles was large to be 4.2 µm. It can be therefore considered that the mixed coated particles were dispersed in the surface of the plated layer to make the hardness of the plated layer lower than that when the coated particles were not mixed, so that the surface roughness was rougher.

Wear resistance of the functional material produced by supporting the aforementioned coated particles on the surface of the substrate material by plating was evaluated in the following procedure. That is, a friction coefficient in the surface of the functional material whose surface was polished was measured using a HEIDON friction testing apparatus, and the wear resistance of the functional material was evaluated based on the measured friction coefficient. Abrasion testing was performed on the following conditions. A number of round trips was set at 100 times, and friction coefficients measured every 10 round trips are shown in the following Table 8.

### <Conditions>

Measuring device: surface property tester "TYPE: 14DR" manufactured by SHINTO Scientific Co., Ltd. manufactured by Science Co., Ltd.
Indenter: SUJ2 ball indenter, diameter ϕ 10 mm
Test speed: 3 mm/sec (equivalent to 9 round trips/min)
Load: 1 kgf
Stroke: 10 mm, sliding in longitudinal direction of test sample
Number of round trips: 100 round trips
Test environment: room temperature, no lubrication
Measurement: measure friction coefficient only in forward way

Further, as a comparative sample, a plated layer was formed on the surface of the substrate material on the same conditions except that an Ni-P bath where the aforementioned coated particles were not dispersed was used. The result where the friction coefficient in the surface of the sample after plating was measured on the same conditions is shown in the following Table 8.

In addition, FIG. 14 shows the relationship between the number of round trips and the friction coefficient. In FIG. 14, the solid line designates the result of the functional material obtained in such a manner that the plated layer containing the coated particles was formed on the surface of the substrate material, and the broken line designates the result of the sample obtained in such a manner that the plated layer containing no coated particles was formed on the surface of the substrate material.

From the following Table 8 and FIG. 14, the following consideration can be made. It is found that when the coated particles in the present invention are mixed in a plated layer, the friction coefficient in the surface of the plated layer can be reduced to be about 10% lower than that of the plated layer alone.

**Table 8**

| Number of round trips (times) | Friction coefficient (-) | |
|---|---|---|
| | With coated particles | Without coated particles |
| 10 | 0.50 | 0.63 |
| 20 | 0.54 | 0.60 |
| 30 | 0.56 | 0.64 |
| 40 | 0.58 | 0.65 |
| 50 | 0.59 | 0.65 |
| 60 | 0.60 | 0.63 |
| 70 | 0.61 | 0.67 |
| 80 | 0.61 | 0.67 |
| 90 | 0.62 | 0.68 |
| 100 | 0.64 | 0.68 |

### Description of Reference Numerals

- 10: Raw material substance
- 12: Explosive substance
- 20: Explosion container
- 22: Booster
- 24: Detonator or detonating cord
- 30: Cooling container
- 32: Coolant
- 34: Stand
- 36: Perforated disk

## Claims

1. A coated particle in which a surface of a base material particle is coated with a carbon particle, the carbon particle being produced by the steps of:
disposing an explosive substance with a detonation velocity of 6,300 m/sec or higher in a periphery of a raw material substance containing an aromatic compound having two or less nitro groups; and
detonating the explosive substance.

2. The coated particle according to claim 1, wherein the carbon particle has been fluorinated.

3. A functional material in which the coated particle according to claim 1 or 2 is supported on a surface of a substrate material.

4. A method for producing a coated particle, comprising the steps of:
disposing an explosive substance with a detonation velocity of 6,300 m/sec or higher in a periphery of a raw material substance containing an aromatic compound having two or less nitro groups;
detonating the explosive substance; and
coating a surface of a base material particle with an obtained carbon particle by a mechanical combination method.

5. The method for producing a coated particle according to claim 4, wherein the carbon particle is subjected to a fluorination treatment, and then, the surface of the base material particle is coated with the carbon particle by the mechanical combination method.

6. A method for producing a functional material, wherein the coated particle obtained by the method according to claim 4 or 5 is supported on a surface of a substrate material.

7. The method according to claim 6, wherein the coated particle is supported on the surface of the substrate material by thermal spraying, rolling or plating.

8. A method for producing a functional material, wherein the coated particle obtained by the method according to claim 4 is supported on a surface of a substrate material, followed by subjecting to a fluorination treatment.

9. The method according to claim 8, wherein the coated particle is supported on the surface of the substrate material by thermal spraying, rolling or plating.
